(19) Europäisches Patentamt
European Patent Office
Office européen des brevets

(11) Numéro de publication : **0 108 655**
**B1**

(12) # FASCICULE DE BREVET EUROPÉEN

(45) Date de publication du fascicule du brevet : **03.12.86**

(51) Int. Cl.[4] : **G 06 F 11/10**, H 03 M 13/00

(21) Numéro de dépôt : **83401791.5**

(22) Date de dépôt : **13.09.83**

(54) **Système de détection et de correction d'erreurs de transmission d'un message binaire utilisant un code cyclique détecteur et correcteur d'erreurs de type Reed-Solomon entrelacé.**

(30) Priorité : **13.09.82 FR 8215403**

(43) Date de publication de la demande : **16.05.84 Bulletin 84/20**

(45) Mention de la délivrance du brevet : **03.12.86 Bulletin 86/49**

(84) Etats contractants désignés : **DE FR GB IT NL**

(56) Documents cités :
**WO-A-82 /021 03**
**US-A- 4 242 752**
**US-A- 4 340 964**
**IBM TECHNICAL DISCLOSURE BULLETIN, vol. 18, no. 8, janvier 1976, pages 2426-2427, New York, US. J. W. MARSCHALL: "Simplified check character/syndrome encoders"**
**Error Correcting Codes by W. Wesley Peterson & E. J. Weldon Jr., 2nd Ed. Pub. 1971**

(73) Titulaire : **CII HONEYWELL BULL**
**94 Avenue Gambetta P.C. OW009**
**F-75020 Paris (FR)**

(72) Inventeur : **Oisel, André**
**Résidence les Nouveaux Horizons Bâtiment 5**
**F-78310 Elancourt (FR)**
Inventeur : **Boulenouar, Abdelhamid**
**La résidence Le Bosquet**
**F-91940 Les Ulis (FR)**
Inventeur : **Le Gleau, Denise**
**94 Avenue Gambetta**
**F-75020 Paris (FR)**

(74) Mandataire : **Gouesmel, Daniel et al**
**BULL S.A. Industrial Property Department 25 avenue de la Grande-Armée**
**F-75016 Paris (FR)**

EP 0 108 655 B1

Il est rappelé que : Dans un délai de neuf mois à compter de la date de publication de la mention de la délivrance du brevet européen toute personne peut faire opposition au brevet européen délivré, auprès de l'Office européen des brevets. L'opposition doit être formée par écrit et motivée. Elle n'est réputée formée qu'après paiement de la taxe d'opposition (Art. 99(1) Convention sur le brevet européen).

Jouve, 18, rue St-Denis, 75001 Paris, France

## Description

La présente invention concerne un système de détection et de correction d'erreurs de transmission de données, utilisant un code cyclique autocorrecteur d'erreurs, de type Reed-Solomon entrelacé.

L'invention s'applique à la détection et à la correction d'erreurs pouvant survenir dans les transmissions de données entre différentes unités d'un système de traitement de l'information. Elle s'applique plus particulièrement à la détection et à la correction d'erreurs de transmission de données entre une unité centrale de traitement et des unités périphériques, telles que des disques magnétiques à très haute densité par exemple.

On sait qu'il est nécessaire de détecter et de corriger les erreurs de transmission de données entre les unités d'un système de traitement de l'information. Généralement, lorsque des données d'un message sont transmises d'une unité à une autre, les données sont codées à l'émission de manière que le décodage effectué à la réception permette de détecter et éventuellement de corriger des erreurs introduites dans le message durant sa transmission. Ces erreurs peuvent également être introduites lors de l'enregistrement d'un message codé sur un support d'enregistrement, tel qu'un disque magnétique, ou lors de la lecture de ce message codé enregistré. Il existe différents systèmes de détection et de correction d'erreurs de transmission de données, utilisant respectivement des codes autocorrecteurs de types variés.

Parmi les codes détecteurs et éventuellement correcteurs d'erreurs, les principaux sont les suivants :

— le code bloc :

Ce code intervient lorsque des données à stocker, sur un disque magnétique par exemple, sont organisées en k blocs présentant chacun une certaine longueur. La valeur k peut être égale par exemple à 256, pour des blocs présentant chacun une longueur d'un octet. Le code bloc transforme le bloc logique utile, en un bloc logique de longueur $n \cdot k$ (n étant un nombre entier), contenant des informations redondantes qui permettent la détection et la correction d'un certain nombre d'erreurs de lecture des données inscrites sur le disque.

— le code systématique :

Ce code est composé par la concaténation d'un bloc utile de longueur k et d'une clé de redondance de longueur r, la longueur totale du bloc transmis étant égale à $k + r$.

— le code algébrique :

Dans un tel code, le codage et le décodage consistent à employer un algorithme utilisant généralement une suite de calculs simples.

— le code externe :

Ce terme désigne la technique de codage définie ci-dessus, et opérant au niveau de blocs d'informations relativement longs. Le code externe est généralement implanté dans un contrôleur ou dans l'intelligence associée à un disque magnétique.

— le code interne :

Ce terme désigne les techniques utilisées pour transformer un flot d'informations logiques en un signal propre à être écrit sur un disque. On l'appelle également code de modulation ou code d'enregistrement. Le codage interne se fait généralement élément binaire par élément binaire (bits), ou sur un nombre d'e. b. relativement faible (quelques e. b. ou quelques dizaines). Autrement dit, les mots de code du code interne sont très courts. Un mot de code du code externe est donc composé d'une succession de mots de codes du code interne.

— le code linéaire :

Un code est dit linéaire lorsqu'une configuration d'erreurs $E_1$ se traduisant par un syndrome $S_1$ et une configuration d'erreurs $E_2$ se traduisant par un syndrome $S_2$, la configuration d'erreurs $E_1 + E_2$ se traduit par le syndrome $S_1 + S_2$. La définition du syndrome sera donnée plus loin.

— le code cyclique :

Un code est dit cyclique lorsque par permutation circulaire des symboles constituant un mot de code, on obtient un autre mot de code au sens strict.

— le code binaire :

Un code est dit binaire lorsque les symboles élémentaires sur lesquels opère l'algorithme du code sont des bits isolés. Il peut arriver que ces symboles élémentaires soient des caractères issus d'un « alphabet » à plus de deux éléments, auquel cas on parlera de code non binaire. Ceci n'empêche pas que chaque caractère puisse être représenté par un certain nombre d'e. b. La distinction s'impose surtout pour décrire correctement les propriétés du code.

— le code tronqué :

Un code est dit tronqué lorsque la longueur totale effective du bloc protégé (données + CLE) est inférieure à la période naturelle du code cyclique ou à celle qui résulte de son entrelacement.

La complexité supplémentaire qui résulte de la troncature est généralement négligeable. Il suffit habituellement de considérer, pour l'étude des propriétés du code, que la partie tronquée est constituée de zéros fictifs.

Le seul handicap est parfois le temps additionnel nécessaire pour explorer la partie tronquée, lors de l'exécution des algorithmes de décodage, mais il existe généralement différents artifices pour tourner

cette difficulté.

On va maintenant donner quelques définitions spécifiques aux corrections d'erreurs :

— le syndrome d'erreur :

On appelle syndrome d'erreur ou tout simplement syndrome, le premier résultat du traitement de la lecture d'un bloc codé, lors de son décodage. La longueur du syndrome est toujours égale à la longueur de la clé.

En l'absence d'erreur de lecture, le syndrome est nul, ce qui permet de détecter facilement la validité du bloc.

En présence d'erreurs, le syndrome constitue le résumé de la configuration d'erreurs, et il permet, dans certaines limites de retrouver la ou les erreurs et de les corriger. Mais généralement l'aspect des erreurs qui se sont produites n'est pas directement reconnaissable dans le syndrome et l'identification des erreurs implique un traitement complémentaire plus ou moins complexe : le décodage.

— la fausse correction :

Lorsqu'une configuration d'erreurs a pour effet de transformer un mot de code en un autre mot de code, ou en un bloc « voisin » d'un autre mot de code, cela se traduit par un décodage erroné, sans que l'utilisateur en soit prévenu. La capacité d'un code à éviter les fausses corrections est une de ses propriétés fondamentales. Mais cette capacité n'est jamais absolue.

La probabilité de fausse correction ne dépend pas seulement du code choisi, de sa redondance, et du compromis correction/détection, mais aussi de la statistique naturelle des erreurs affectant le message reçu.

— l'erreur résiduelle :

L'erreur résiduelle est le résultat d'une erreur non détectée ou d'une fausse correction.

— la propagation des erreurs :

Le résultat d'une fausse correction est généralement de laisser subsister les erreurs d'origine et de rajouter de nouvelles erreurs à l'intérieur du bloc. On assiste donc à un phénomène de propagation des erreurs qui peut affecter la longueur totale d'un mot de code.

Ce phénomène existe pour le code externe, mais il peut aussi exister pour le code interne. Cela se traduit par le fait que les erreurs logiques auxquelles le code externe doit faire face peuvent être plus longues que les erreurs physiques qui les ont engendrées.

Les codes les plus utilisés pour la détection des erreurs sont les codes cycliques.

La première utilisation des codes cycliques, qui s'est largement répandue, est la détection des erreurs.

L'opération de détection d'erreur consiste à utiliser, lors d'une réception (télécommunications) ou d'une lecture (enregistrement), une clé de redondance concaténée au message (code systématique) lors de son émission. Pour la détection des erreurs, on peut utiliser une clé relativement courte (quelques octets) pour des blocs relativement longs (quelques milliers d'octets).

Le but de la clé est de pouvoir trier les messages reçus en deux catégories :

— celle des messages qui coïncident avec des mots de code, auquel cas on présumera qu'il n'y a pas d'erreur,

— celle des autres messages qui ne coïncident pas exactement avec les mots du code ; dans ce cas, on saura avec certitude qu'il s'est produit une ou plusieurs erreurs.

Généralement, dans l'utilisation de codes cycliques, on ne va pas au-delà de la détection des erreurs ; on ne cherche pas à corriger les erreurs à partir de l'information fournie par la clé. On demande simplement une répétition du message (télécommunications) ou une relecture (enregistrement magnétique).

Le procédé de détection d'erreurs par code cyclique est simple (peu de matériel), efficace (peu de redondance) et puissant (possibilité de récupérer l'information tout au moins lorsque l'on n'a que des erreurs aléatoires).

Ce procédé est toutefois mis en défaut dans trois cas :

— lorsqu'il existe des erreurs permanentes, ce qui existe rarement dans les télécommunications mais devient fréquent dans l'enregistrement à haute densité, à cause des défauts physiques du support,

— lorsque le temps d'acheminement des messages interdit la répétition (cas des transmissions spatiales),

— lorsqu'une erreur d'une certaine importance transforme un mot de code en un autre mot de code, cette erreur n'étant alors pas détectée.

Les codes cycliques fournissent une réponse à ces objections, si la configuration d'erreurs reste dans des limites raisonnables, et à condition d'adjoindre au bloc d'information une clé de longueur suffisante, il est possible d'utiliser cette redondance pour corriger les erreurs.

Parmi les codes cycliques les plus utilisés, le plus simple est le code de Hamming, correcteur de 1 e. b. Son inconvénient réside dans le fait qu'une erreur portant sur plus de 1 e. b. donne un syndrome qui est décodé comme une erreur de 1 e. b. (généralement différent de chacun des e. b. constituant la véritable configuration d'erreurs). Ceci a pour inconvénient de provoquer une fausse correction.

L'adjonction d'un e. b. de parité permet d'améliorer la situation. Elle permet de distinguer le cas d'une erreur de 1 e. b. (que l'on corrige effectivement) de celui d'une erreur de 2 e. b. (erreur détectée mais non corrigible).

D'une façon générale, les codes cycliques conduisent à une grande simplicité de réalisation des systèmes de détection et de correction d'erreur toutes les fois que l'information à protéger se présente sous la forme de longues chaînes séquentielles, (c'est le cas en télécommunication et en enregistrement magnétique. Ce n'est pas le cas dans les mémoires à accès aléatoires).

Tous les calculs de transcodages nécessaires pour engendrer des clés (codes systématiques) ou des syndromes de longueur relativement faible (faible taux de redondance) peuvent être effectués au moyen d'un système séquentiel câblé qui comprend, de façon connue :

— un registre à décalage (série ou série-parallèle) dans lequel le nombre de bascules est égal au nombre d'e. b. redondance formant la clé ;

— un réseau de rebouclage, avec des prises intermédiaires qui introduisent un élément « perturbateur » permettant d'engendrer des phénomènes cycliques de périodes très supérieures à la longueur de la clé,

— un certain nombre de portes de type « OU exclusif ».

Cette structure séquentielle, très simple, est facile à réaliser sous forme d'un circuit unique intégré à grande échelle.

On connaît un système de codage utilisant un code de REED-SOLOMON pour le codage d'un message binaire. Ce système est par exemple celui qui est décrit dans la demande internationale de brevet WO 82/02103. Il comprend des ensembles successifs de registres à décalage reliés en série ayant chacun un nombre de registres à décalage égal à la profondeur d'entrelacement du code. Le nombre des ensembles de registres dépend du degré du polynome générateur du code cyclique choisi. Ce système comprend aussi des rebouclages entre les sorties et les entrées des différents registres pour multiplier le message par les coefficients du polynome générateur du code cyclique obtenus à partir d'un corps de Galois.

Ce système, s'il permet bien le codage d'un message, ne permet toutefois pas la détection et le décodage d'un syndrome d'erreurs dans le message ainsi codé.

La détection et le décodage d'un syndrome d'erreurs dans un message codé selon un code de REED-SOLOMON, sont décrits par exemple dans le document intitulé « Error correcting codes » by WESLEY PETERSON and E. J. WELDON Jr., 2 nd Edition. 1971. Le décodage du syndrome par le système décrit dans cette revue est effectué par un agencement de circuits logiques qui rendent le système peu rapide. De plus, ces circuits ne permettent pas de déterminer si les erreurs détectées sont des erreurs simples ou des erreurs multiples, et ceci dans chaque sous-bloc de données.

L'invention a pour but de remédier à ces inconvénients en réalisant un système performant et rapide de détection, de décodage et de correction d'erreurs, utilisant un code de REED-SOLOMON ; le décodage rapide des erreurs est obtenu grâce à une mémoire de configuration d'erreurs et grâce à des moyens reliés à cette mémoire et permettant d'indiquer la présence des erreurs simples ou multiples dans chaque sous-bloc du message codé.

L'avantage du système de l'invention résulte essentiellement de l'utilisation d'un code REED-SOLOMON dont les propriétés essentielles sont les suivantes :

— c'est un code non binaire, c'est-à-dire opérant sur des données élémentaires qui sont des caractères, et non des e. b. isolés. Ces caractères peuvent être extraits d'un alphabet binaire, c'est-à-dire être codés sur m. e. b.,

— ce code présente une « distance logique optimale », c'est-à-dire qu'il réalise la meilleure performance (compromis correction/détection) pour une redondance donnée ; ceci par rapport à d'autres codes construits selon d'autres critères. La notion de distance logique sera définie plus loin,

— la période de ce code est relativement courte. Elle est liée à la longueur m des caractères par une relation très rigide. Ceci limite l'éventail des choix possibles pour protéger un bloc de longueur donnée,

— le code REED-SOLOMON permet, si l'on choisit correctement ses paramètres, de corriger les erreurs multiples. Ce code est très supérieur aux codes classiques par sa souplesse d'adaptation aux techniques connexes de traitement du signal. L'utilisation de ce code est la solution la plus simple au traitement de situations d'erreurs complexes,

— il constitue la meilleure réponse au problème du traitement des erreurs dans les dispositifs d'enregistrement à haute densité, tels que les bandes magnétiques, les disques magnétiques, les disques optiques numériques.

L'invention a pour objet un système de détection et de correction d'erreurs de transmission dans un message traité selon un code cyclique de type REED-SOLOMON entrelacé, et constitué par au moins un sous-bloc utile de multiplets dont le nombre définit la profondeur d'entrelacement du code, comprenant :

— des ensembles successifs de registres à décalages reliés en série, ayant chacun un nombre de registres à décalage égal à la profondeur d'entrelacement du code, le nombre des ensembles dépendant du degré du polynôme générateur du code cyclique choisi,

— des circuits de rebouclage entre les sorties et les entrées des différents registres, pour multiplier le message par les coefficients du polynôme générateur du code cyclique, obtenus à partir des éléments primitifs d'un corps de Galois prédéterminé,

— des moyens de détection dont des entrées sont respectivement reliées à des sorties de chaque premier registre de chaque ensemble, pour détecter la présence d'un syndrome d'erreurs éventuelles dans le message, ce syndrome étant composé de l'ensemble des syndromes de chacun des sous-blocs,

— des moyens de décodage du syndrome d'erreurs éventuelles reliés aux moyens de détection de ce syndrome, le décodage du syndrome d'erreurs étant effectué sous-bloc par sous-bloc, caractérisé en ce que les moyens de décodage du syndrome d'erreurs comprennent une mémoire de configurations d'erreurs, reliée aux moyens de détection de ce syndrome, et des moyens reliés à des sorties de la mémoire pour indiquer la présence d'erreurs dans tout le bloc de données et, parmi ces erreurs, l'existence d'erreurs simples ou d'erreurs multiples dans chacun des sous-blocs.

Selon une autre caractéristique, les moyens d'indication sont reliés à un compteur recevant les impulsions d'une horloge de commande de décalage des registres de manière à repérer les positions de chaque multiplet qui, dans le message, est affecté d'erreurs, et de manière à extraire, grâce à un signal d'extraction et de remise à zéro, un à un, du dernier registre du dernier ensemble, des multiplets représentant respectivement les configurations des erreurs éventuelles dans les multiplets, les moyens d'indication comportant une logique permettant de mémoriser les éventuelles erreurs simples ou doubles groupées dans chacun des sous-blocs.

Selon une autre caractéristique, le système comprend une autre mémoire, reliée aux sorties du dernier registre du dernier ensemble, pour enregistrer les positions des multiplets affectés d'erreurs.

Selon une autre caractéristique, le système comprend une mémoire tampon dans laquelle est enregistré chaque bloc de données d'un message à décoder, les multiplets utiles du message étant accompagnés de multiplets constituant une clé, de sorte que lorsqu'aucune erreur n'est détectée, les multiplets utiles sont transmis directement à un utilisateur, et de sorte qu'en présence d'erreurs détectées, le contenu de l'autre mémoire permette de corriger par masquage dans la mémoire tampon les multiplets qui présentent des erreurs, avant leur transmission à un utilisateur.

Selon une autre caractéristique, les moyens de détection de syndrome d'erreurs comprennent pour chaque premier registre de chaque ensemble une porte de type « OU » dont les entrées sont reliées aux sorties de ce registre et dont une sortie est reliée à une entrée de la mémoire d'enregistrement des configurations d'erreurs.

Ces caractéristiques et avantages de l'invention ressortiront mieux de la description qui va suivre, donnée en référence aux dessins annexés dans lesquels :

la figure 1 représente schématiquement un premier mode de réalisation d'un système de codage, de détection et de correction d'erreurs dans un message binaire, conforme à l'invention,

la figure 2 représente un autre mode de réalisation du système de l'invention,

les figures 3a et 3b représentent les matrices de multiplication appartenant aux circuits de rebouclage du système de l'invention,

les figures 4a et 4b représentent schématiquement le syndrome d'erreurs contenu dans les registres du système, lors d'une décodification des erreurs simples contenues dans un message,

les figures 5a et 5b représentent schématiquement le syndrome d'erreurs contenu dans les registres du système, lors d'une décodification des erreurs multiples contenues dans un message,

la figure 6 représente la numérotation des octets dans un bloc, pour un entrelacement par 3,

la figure 7 est une table qui permet d'interpréter la configuration des erreurs, en fonction du nombre d'erreurs décodées.

Avant de décrire la structure et le fonctionnement du système de l'invention, il est utile de rappeler ce qu'est un code Reed-Solomon : c'est un code algébrique, linéaire et cyclique dont les propriétés essentielles sont les suivantes :

— Il opère sur des blocs organisés en n sous-ensembles de m. e. b., tels que $n = 2^{m-1}$.

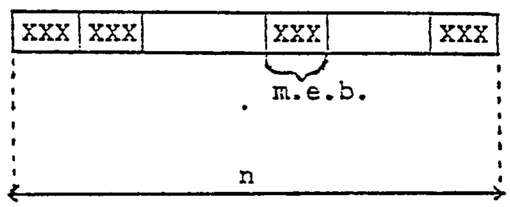


n constitue la longueur ou période du code. Ce code obéit à deux théorèmes qui concernent les codes linéaires d'une part, et les codes de Reed-Solomon proprement dit, d'autre part. Ces théorèmes sont les suivants :

— Si C est un code linéaire défini par les paramètres suivants :

n : longueur totale du bloc (information utile + clé),

k : longueur du bloc de données utiles,

r : longueur de la clé ($r = n - k$),

d : distance minimum du code.

alors, $n - k = d - 1$ ou encore $r = d - 1$

— Dans un code de Reed-Solomon :

$d = n - k + 1$ ou encore $d = r + 1$ et, dans ce cas, la longueur de la clé est minimum.

— Le polynome générateur d'un code Reed-Solomon, est de la forme :

$$G(x) = \prod_{i=1}^{i=d-1} (x - \alpha^i)$$

D'une façon plus générale, les codes de Reed-Solomon entrelacés sont de la forme :

$$G(x) = \prod_{i=0}^{i=d-2} (x - \alpha^{l+i})$$

l représentant un entier positif, négatif ou nul.

Les racines de G(x) sont $\alpha^l$, $\alpha^{l-1}$, $\alpha^{l-2}$, $\alpha^{l-3}$, $\alpha^{l-4}$, si la distance logique d du code est égale à 6.

Si on développe G(x) avec ses racines, on a $G(x) = (x - \alpha^l)(x - \alpha^{l-1})(x - \alpha^{l-2})(x - \alpha^{l-3})(x - a^{l-4})$. Si on choisit $l = -2$, on obtient $G(x) = (x - \alpha^{-2})(x - \alpha^{-l})(x - l)(x - \alpha)(x - \alpha^2)$. Le développement de G(x) est alors le suivant :

$$G(x) = x^5 + Ax^4 + Bx^3 + Bx^2 + Ax + 1$$

avec

$$A = \alpha^{-2} + \alpha^{-1} + 1 + \alpha + \alpha^2$$

et

$$B = \alpha^2 + \alpha^3 + \alpha^{-3} + \alpha^{-2} .$$

α est l'élément primitif d'un corps de Galois prédéterminé. On montrera plus loin comment sont obtenus les coefficients A et B dans le système de l'invention.

Dans l'exemple de réalisation du système de l'invention, qui sera aussi décrit plus loin en détail, on considèrera que la longueur k du bloc d'informations utiles est de 250 octets, la longueur totale n du bloc (informations utiles + clé) étant 255 octets et la distance logique étant d = 6. Compte tenu des théorèmes mentionnés plus haut, la clé r est égale à d — l et représente donc 5 octets. Le code de base s'exprime symboliquement sous la forme C (255, 250, 6) et le polynôme générateur de ce code de base est de la forme :

$$G(x) = x^5 + Ax^4 + Bx^3 + Bx^2 + Ax + 1$$

$$G(x) = x^5 = A(x^4 + x) + B(x^3 + x^2) + 1 .$$

Dans l'invention, le code est entrelacé. L'entrelacement est une décomposition d'un bloc d'informations en un certain nombre de sous-blocs élementaires, chacun d'entre eux ayant une longueur ne dépassant pas la longueur du mot code du code de base choisi. Un entrelacement par 3 est représenté ci-dessous.

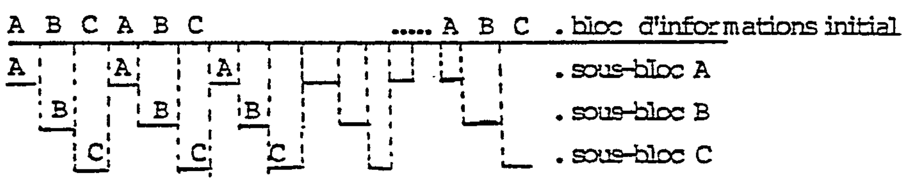


On appelle « profondeur P d'entrelacement » le nombre de sous-blocs élémentaires déduits d'un bloc d'informations initial.

L'entrelacement permet, pour un code de base de longueur donnée, de protéger un bloc d'informations, de longueur plus importante.

Dans le code de base choisi en exemple plus haut, la longueur n = 255 octets et avec une profondeur d'entrelacement p = 3, il est en fait possible d'allonger artificiellement la période de base du code, à 255 × 3 = 765 octets. Sur ces 765 octets, 750 concernent des données utiles et 3 × 5 = 15 octets concernent la clé. Les 750 octets de données utiles résultant de cet entrelacement, permettent de protéger facilement un bloc de 512 octets. Ce code entrelacé permet de plus d'opérer sur des données organisées sur des mots de 8 e. b., en parallèle.

Un autre choix important dans le système de l'invention est celui de la distance logique d = r + l.

Dans l'exemple considéré où la clé r = 5, on a d = 6. Un raisonnement simple montre qu'un code ayant une distance logique minimum d, peut corriger c erreurs et en détecter ∂, c et ∂ étant liés par les relations :

$$c \leqslant \left| \frac{d-1}{2} \right| \qquad \text{et} \qquad c + \hat{c} = d - 1$$

le symbole ⌊ ⌋ désignant la partie entière immédiatement inférieure de la valeur contenue dans ce symbole.

Lorsque d = 6, on a donc $c \leq 2$ et $c + \partial = 5$. Il en résulte plusieurs solutions ($S_1$, $S_2$, $S_3$), pour la capacité de détection et de correction du code de base C(255, 250, 6) choisi en exemple plus haut. Ces solutions sont exprimées dans le tableau ci-dessous, pour une clé de 15 octets.

| Solutions | Nombre $C_e$ d'erreurs corrigibles | Nombre $\partial$ d'erreurs détectées |
|---|---|---|
| $S_1$ | 0 | 5 |
| $S_2$ | 1 | 4 |
| $S_3$ | 2 | 3 |

Le fait d'entrelacer le code a deux conséquences essentielles qui se résument de la manière suivante, pour le code choisi :

a) c'est un artifice pour augmenter la période du code qui passe, comme on le voit, de 255 à 765. Et cela rend possible la « couverture » d'un bloc de 512 octets utiles.

b) cela permet d'augmenter localement la puissance de détection et de correction du code. En effet : une erreur affectant trois octets consécutifs, et qui ne serait pas corrigible par le code de base, va ici affecter un octet et un seul dans chacun des trois mots de code.

Ainsi, certains paquets d'erreurs, pouvant atteindre une longueur de 24 e. b., se comporteront, vis-à-vis du code, comme des erreurs simples :

| | | |
|---|---|---|
| X..X.XX. | XXXX.XX. | X....XXX |

De même, comme l'indiquent les deux schémas ci-dessous, on peut être assuré que n'importe quel paquet d'erreurs de 17 e. b. ou moins se comportera comme une erreur simple :

| | | | |
|---|---|---|---|
| .......X | XXXXXXXX | XXXXXXXX | ........ |

3 octets

| | | | |
|---|---|---|---|
| ........ | XXXXXXXX | XXXXXXXX | X....... |

3 octets

Bien évidemment, de telles situations pourront se produire deux fois à l'intérieur du bloc puisque le code de base est correcteur d'erreurs doubles. Mais on remarque également que toute situation d'erreur s'étendant sur moins de 6 octets consécutifs, c'est-à-dire certains cas d'erreurs de 48 e. b. comme ci-dessous :

| | | | | | |
|---|---|---|---|---|---|
| X...X.X. | .X.X..X. | XXXX.XX. | .X...X.. | XXX...XX | X.XXXXXX |

6 octets (soit 48 e.b.)

De même que toute situation d'erreur s'étendant sur 41 e. b. consécutifs ou moins, comme ci-dessous :

| | | | | | |
|---|---|---|---|---|---|
| XXXXXXXX | XXXXXXXX | XXXXXXXX | XXXXXXXX | XXXXXXXX | X....... |

41 e.b.

| | | | | | |
|---|---|---|---|---|---|
| .......X | XXXXXXXX | XXXXXXXX | XXXXXXXX | XXXXXXXX | XXXXXXXX |

41 e.b.

sera corrigible puisque chacun des trois mots de code entrelacés sera en présence d'une erreur ne portant que sur deux octets.

Le nombre de situations d'erreurs effectivement corrigibles dans un code entrelacé est trop grand pour que l'on puisse songer à établir un classement général.

La figure 1 représente schématiquement un système de codage, de détection et de correction d'erreurs dans un message binaire, utilisant un code cyclique de type Reed-Solomon entrelacé. Comme on l'a indiqué plus haut, ce message est constitué par au moins un bloc de multiplets qui présentent respectivement le même nombre de données binaires. Pour faciliter la compréhension, on supposera que les multiplets sont des octets que le code de base est C(255, 250, 6), que la profondeur d'entrelacement p = 3 et que la distance logique d = 6, le polynôme générateur de ce code cyclique est un polynôme symétrique, qui pour l'exemple de réalisation choisi est de la forme :

$$G(x) = x^5 + Ax^4 + Bx^3 + Bx^2 + Ax + 1 .$$

Le système comprend un registre à décalage formé d'une pluralité d'ensembles X, Y, Z, T, U, de registres à décalage à entrées et sorties parallèles. Ces registres sont reliés en série et sont reliés à une horloge H qui applique sur leurs entrées CP des impulsions de commande de décalages. Le nombre des ensembles de registres est égal au degré du polynôme générateur du code cyclique du message à traiter. Dans l'exemple considéré, le nombre des ensembles de registres est égal à 5, tandis que chaque ensemble comprend trois registres. Ce nombre correspond à la profondeur d'entrelacement du code cyclique, de type Reed-Solomon choisi. Dans cet exemple de réalisation, les entrées et les sorties des registres qui n'ont pas été représentées en détail sont au nombre de huit puisque les multiplets sont des octets. Il est bien entendu que pour une profondeur d'entrelacement par n, chaque ensemble comporterait n registres.

A l'initialisation, tous les registres sont remis à zéro par un signal $\overline{MR}$ appliqué sur les entrées CL de remise à zéro de chacun de ces registres. Après cette initialisation, le système est apte à recevoir les multiplets d'un message à coder, de manière à lui adjoindre une clé de contrôle formée de multiplets obtenu par la concaténation avec les multiplets utiles du message. Ce premier registre peut également recevoir les multiplets d'un message codé contenant une clé et présentant éventuellement des erreurs à détecter et à corriger.

Dans un exemple particulier d'application, ce système permet, lorsque l'on désire inscrire un message sur un disque magnétique d'un périphérique magnétique M, d'ajouter à ce message des multiplets constituant une clé. Les multiplets utiles parviennent directement au périphérique magnétique M par un BUS.

Dans l'exemple de réalisation considéré à code entrelacé par 3, cette clé comporte 15 multiplets formés chacun d'un octet ($Q_0$, $Q_1$ ... $Q_7$ par exemple). On a désigné par $D_0$, $D_1$ ... $D_7$ les éléments binaires de chaque octet d'un message parvenant sur les entrées DIN du système. Ces multiplets peuvent être ceux d'un message auquel on désire ajouter une clé avant son inscription sur un disque magnétique par exemple ; mais ils peuvent être également ceux d'un message codé provenant par exemple d'un disque magnétique, message que l'on désire décoder afin de rechercher les multiplets qui contiennent éventuellement des erreurs dont certaines pourront être corrigées. Le système comprend aussi un premier additionneur $C_1$ de type « OU exclusif » qui présente des sorties qui sont respectivement reliées aux entrées du premier registre 1 du premier ensemble X de registres. Les multiplets à traiter étant des octets, le premier additionneur $C_1$ comporte huit sorties. Cet additionneur comprend des entrées (8 entrées dans l'exemple de réalisation), qui sont reliées respectivement aux sorties (8 sorties dans l'exemple de réalisation) du dernier registre n du dernier ensemble U des registres. D'autres entrées de l'additionneur $C_1$ reçoivent les données $D_0$, $D_1$, $D_2$ ... $D_7$ de chaque multiplet d'un message à coder ou à décoder. Le système comprend aussi d'autres additionneurs intermédiaires $C_2$, $C_3$, $C_4$, $C_5$, de type « OU exclusif ». Ces additionneurs intermédiaires sont respectivement reliés par des entrées et des sorties, avec les sorties et les entrées des ensembles successifs X, Y, Z, T, U, de registres à décalage. D'autres entrées de ces additionneurs intermédiaires (8 entrées dans l'exemple de réalisation) sont respectivement reliées par des circuits $R_1$, $R_2$ de rebouclage, avec les entrées du premier registre 1 du premier ensemble X.

Chacun des circuits de rebouclage $R_1$, $R_2$ comprend des matrices A, B qui seront décrites plus loin en détail et qui permettent de multiplier les données de chaque multiplet d'un message parvenant aux entrées du système, par les coefficients du polynôme générateur du code cyclique du message, de type Reed-Solomon, décrit plus haut. Ces coefficients sont obtenus à partir de l'élément primitif d'un corps de Galois prédéterminé. Dans l'exemple de réalisation considéré, ces matrices sont des matrices carrées présentant huit entrées et huit sorties. Ces matrices appliquent les valeurs binaires des coefficients du polynôme générateur sur les entrées des additionneurs intermédiaires $C_2$, $C_3$, $C_4$, $C_5$.

Le système comprend en outre des moyens logiques de sélection de modes de fonctionnement du système. Ces moyens logiques comportent un premier groupe $P_1$ de portes de type « ET ». Le nombre de ces portes est égal à celui des données de chaque multiplet d'un message reçu par le système. Ces portes ne sont pas représentées en détail sur la figure ; ce sont des portes de type ET, bien connues dans l'état de la technique, qui présentent chacune deux entrées et une sortie. Les premières entrées DIN de ces portes reçoivent respectivement les données $D_0$, $D_1$ ... $D_7$ de chaque multiplet (octet) d'un message à coder ou à décoder, et les deuxièmes entrées de ces portes reçoivent un signal de validation VIN, soit

pour valider le codage, soit pour valider la détection d'erreurs dans un message. Les sorties de ces portes sont respectivement reliées aux entrées du premier additionneur $C_1$, de type « OU exclusif ». Les moyens logiques de sélection du mode de fonctionnement du système comportent aussi un second groupe $P_2$ de portes de type ET. Ces portes qui ne sont pas représentées en détail sur la figure sont des portes à deux entrées et une sortie. Leur nombre est égal à celui des données de chaque multiplet d'un message, c'est-à-dire huit dans l'exemple de réalisation considéré. Les premières entrées des portes de ce deuxième groupe $P_2$ sont respectivement reliées aux sorties du premier additionneur $C_1$, et les deuxièmes entrées de ces portes sont aptes à recevoir un signal de validation VCOEFF ; ce signal de validation intervient soit pour le codage, soit pour le décodage d'un message, de manière à valider les multiplications à effectuer grâce aux matrices A et B de multiplication, contenues dans les circuits de rebouclage $R_1$, $R_2$. Les sorties des portes du deuxième groupe $P_2$ sont respectivement reliées à des entrées de commande des matrices B. Les moyens logiques comprennent aussi un troisième groupe $P_3$ de portes ET dont le nombre est égal à celui des données de chaque multiplet d'un message à coder ou à décoder (8 dans l'exemple considéré). Chacune de ces portes qui ne sont pas représentées ici en détail, présente une première et une deuxième entrée. Les premières entrées des portes du groupe $P_3$ sont respectivement reliées aux sorties du dernier registre du dernier ensemble U. Les premières entrées de ces portes reçoivent un signal de validation VREB de rebouclage, pour le codage ou le décodage d'un message. Enfin, les moyens logiques de sélection de mode de fonctionnement du système comprennent une porte de sortie $P_4$ à trois états. Cette porte présente des entrées (8 entrées dans l'exemple considéré) qui sont respectivement reliées aux sorties du dernier registre n du dernier ensemble U. Cette porte, bien connue dans l'état de la technique, n'est pas représentée en détail sur la figure. Elle fournit sur des sorties DOUT, soit des multiplets d'une clé à ajouter à un message pour le codage de celui-ci (ces multiplets étant des octets ($Q_0$, $Q_1$ ... $Q_7$) dans l'exemple considéré), elle fournit éventuellement des multiplets résultant d'un syndrome d'erreurs, lors du décodage d'un message. Elle présente une entrée de commande apte à recevoir un signal de validation EM lorsque l'on désire, dans certaines conditions qui seront décrites plus loin en détail, extraire le multiplet contenu dans le registre n du dernier ensemble U.

En fait, la porte $P_4$ est commandée par un circuit $P_5$ utilisant une logique combinatoire. Ce circuit fournit un signal de validation VOUT qui dépend de la valeur binaire des signaux REP, $a_0$, $a_1$, $a_2$, qu'il reçoit.

Le signal REP est notamment un signal de remise à zéro qui est également fourni aux registres des ensembles et un circuit logique $P_6$ spécifique de remise à zéro du dernier registre de l'ensemble U, ce dernier registre dépend en fait de la profondeur d'entrelacement. Les signaux $a_0$, $a_1$, $a_2$ permettent de sélectionner les modes de fonctionnement du dispositif, qui seront décrits plus loin. En fait, ces modes de fonctionnement peuvent être les suivants : calcul du syndrome ou de la clé (lorsque le contenu de tous les ensembles de registres actifs a été vidé), vidage des registres avec remise à zéro, vidage des registres avec conservation de leur contenu (lorsque le contenu de tous les ensembles de registres actifs a été vidé), décodage du syndrome d'erreurs, changement des registres.

L'état logique haut du signal REP appliqué au circuit $P_5$, valide par le signal VOUT, les sorties DOUT du circuit $P_4$, en mode « décodage ».

Le front descendant de ce signal permet de remettre à zéro le dernier registre actif de l'ensemble U, par l'intermédiaire du circuit $P_6$ de remise à zéro. Ce circuit reçoit également le signal $\overline{MR}$ de remise à zéro de tous les ensembles du registre (utilisé lors de l'initialisation), ainsi que des signaux binaires $S_0$, $S_1$ qui permettent de définir la profondeur P d'entrelacement choisie, pour le code considéré. Cette profondeur peut avoir, dans l'exemple de réalisation décrit, l'une des valeurs 1, 2, 3 ou 5.

D'une manière générale, les signaux de commande tels que VREB, VCOEFF, VIN, $\overline{MR}$, REP, $S_0$, $S_1$, $a_0$, $a_1$, $a_2$ sont fournis par exemple par un processeur qui fournit ou reçoit les données, ou par un séquenceur commandé par ce processeur.

Le système comprend aussi des moyens de détection $D_1$, $D_2$, $D_3$, $D_4$ présentant chacun des entrées qui sont respectivement reliées aux sorties du premier registre de chacun des ensembles de registres X, Y, Z, T, Q. Ces moyens de détection permettent, comme on le verra plus loin en détail, de détecter la présence d'un syndrome d'erreurs éventuelles dans un message décodé. Ils sont constitués par des portes OU qui présentent respectivement huit entrées dans l'exemple de réalisation considéré.

Les sorties des portes $D_1$, $D_2$, $D_3$, $D_4$, sont reliées respectivement aux entrées de moyens de décodage D du syndrome d'erreurs éventuelles. Ces moyens de décodage D du syndrome d'erreurs éventuelles. Ces moyens de décodage comprennent une table EC d'enregistrement de configuration d'erreurs dont les entrées sont reliées aux sorties des moyens de détection $D_1$, $D_2$, $D_3$, $D_4$, $D_5$. Les moyens de décodage comprennent aussi des moyens d'indication I, reliés à des sorties de la table E pour indiquer par un signal ER, la présence d'erreurs dans un message décodé. Ces moyens d'indication permettent aussi, d'indiquer respectivement par des signaux ES et EM, la présence d'erreurs simples ou d'erreurs multiples parmi les erreurs détectées dans le message. Ces moyens d'indication sont reliés par leurs sorties à un compteur C qui reçoit aussi les impulsions de l'horloge H.

Les moyens d'indication (I) sont constitués par une logique combinatoire et séquentielle qui, dans le cas d'un entrelacement par 3 par exemple, permet d'indiquer la présence d'une erreur simple ou double groupée dans chaque sous-bloc d'informations. La présence d'erreur dans tout le bloc, est indiquée par le signal ER ; le décodage des erreurs se fait sous-bloc par sous-bloc ; s'il y a une erreur simple groupée,

elle est alors indiquée par le signal ES, lorsque l'erreur est double et groupée elle est indiquée par le signal EM. Les signaux binaires $S_0$, $S_1$ appliqués sur des entrées des moyens d'indication I permettent de définir la profondeur d'entrelacement choisie.

Le compteur (C) permet, comme on le verra plus loin en détail, de repérer les positions de chaque multiplet qui, dans le message est affecté d'erreurs. Il permet de commander les décalages de manière à extraire un à un du dernier registre n du dernier ensemble U, des multiplets représentant respectivement les configurations des erreurs dans les multiplets qui, dans le message, sont affectés d'erreurs. La position de chaque multiplet qui, dans le message est affecté d'erreurs, ainsi que les configurations des erreurs dans ces multiplets définissent une table d'erreurs, enregistrées dans une mémoire TE. Le système comprend aussi une mémoire tampon MT dans laquelle est enregistré chaque bloc de données d'un message à décoder provenant d'un disque magnétique M par exemple. Dans cette mémoire tampon, les multiplets utiles du message sont séparés des multiplets constituant la clé. Lorsqu'aucune erreur n'est détectée au décodage, les multiplets utiles sont transmis directement à un utilisateur par des sorties UT, tandis qu'en présence d'erreurs détectées au décodage, la table d'erreurs TE permet de corriger les multiplets qui, dans la mémoire tampon MT, présentent des erreurs. Il en résulte alors que le message transmis à l'utilisateur ne comporte plus d'erreurs.

La figure 2 représente schématiquement, un autre mode de réalisation du système, selon l'invention. Les mêmes éléments portent les mêmes références sur cette figure et sur la figure 1. Le système fonctionne d'une façon semblable dans les deux modes de réalisation ; toutefois, dans le mode de réalisation représenté sur la figure 2, le système permet de choisir entre deux codes Reed-Solomon cycliques du message. Ce choix résulte de la présence des multiplexeurs MX1 et MX2, ainsi que de la présence d'une matrice E d'obtention des coefficients d'un autre polynôme générateur de code cyclique du message. Les entrées du premier multiplexeur MX1, sont reliées aux sorties de la matrice A donnant certains des coefficients du polynôme générateur d'un premier code défini plus haut, et aux sorties de la matrice E donnant les coefficients de l'autre polynôme générateur choisi. Dans l'exemple considéré le deuxième multiplexeur MX2 a des entrées qui sont reliées d'une part aux sorties du dernier registre du deuxième ensemble Y et, d'autre part, aux sorties du dernier registre de l'avant dernier ensemble T. Les sorties de ce deuxième multiplexeur sont reliées aux entrées de l'additionneur $C_5$, qui dans le premier mode de réalisation étaient reliées aux sorties de l'ensemble T. Chacun des multiplexeurs MX1, MX2 reçoit un signal SC qui permet de sélectionner le code choisi. Ce signal est aussi appliqué à la table EC d'enregistrement de configuration d'erreurs pour différencier les différentes configurations d'erreurs pouvant résulter de chacun des codes. Il permet donc grâce aux multiplexeurs, soit de choisir le code de base (255, 250, 6), déjà décrit, faisant intervenir les matrices A et B à travers les circuits de rebouclages $R_1$, $R_2$, soit de choisir un nouveau code faisant intervenir seulement la matrice E, à travers le circuit $R_1$. Dans l'exemple considéré, le nouveau code base est : C' (255, 252, 4). Dans ce nouveau code, la distance minimum du code est d = 4, le nombre d'erreurs corrigibles est $C_0 = 1$, tandis que le nombre d'erreurs détectées est $\partial = 2$. Le code choisi est un code dégénéré dont le polynôme générateur G'(x) est de la forme :

$$G'(x) = (x - \alpha^{-1})\,(x - 1)\,(x - \alpha)\,.$$

$\alpha$ est un élément primitif d'un corps de Galois C. G. ($2^8$) ; ce polynôme peut s'écrire sous la forme d'un polynôme symétrique :

$$G'(x) = x^3 + E(x^2 + x) + 1\,.$$

La matrice E représentée sur la figure permet d'obtenir le coefficient de ce nouveau polynôme générateur, qui fournit un code de redondance 3 (3 octets), alors que le code obtenu à partir des matrices A et B était de redondance 5 (5 octets). Dans l'exemple considéré, les multiplexeurs MX1, MX2 par la commande SC, permettent ainsi d'inhiber les troisième et quatrième ensembles Z, T de registres dont les contenus sont mis à zéro.

A part cette particularité, le système fonctionne de la même façon que pour le mode de réalisation de la figure 1.

En fait, comme indiqué plus haut, il est possible de choisir quatre profondeurs différentes d'entrelacement (1, 2, 3, 5) (grâce aux signaux $S_0$, $S_1$), pour deux codes différents (grâce au signal SC). Il en résulte donc huit façons possibles de choisir un polynome générateur.

Les figures 3a et 3b représentent schématiquement les matrices de multiplication A et B permettant d'obtenir les coefficients du polynôme générateur du code cyclique, de type Reed-Solomon, choisi.

Les matrices de multiplication A et B sont des matrices câblées qui, dans le cas d'un message dont les multiplets sont des octets, contiennent $8 \times 8 = 64$ e. b. 0 ou 1. Les sorties de ces matrices sont respectivement les sorties des portes de type « OU exclusif ». Sur les entrées de ces portes sont appliqués les niveaux logiques 1 de la colonne qui leur correspond. Les portes sont référencées $A_0$, $A_1$ ... $A_7$ pour la matrice A et $B_0$, $B_1$ ... $B_7$ pour la matrice B. Dans l'invention, la caractéristique essentielle de ces matrices est que les coefficients qu'elles contiennent sont obtenus à partir d'une recherche systématique effectuée dans 16 corps de Galois contenant $2^8 = 256$ éléments et à partir des coefficients $A = \alpha^{-2} +$

$\alpha^{-1} + 1 + \alpha + \alpha^2$ et $B = \alpha^{-2} + \alpha^{-3} + \alpha^2 + \alpha^3$ du polynôme générateur choisi. Chacune de ces matrices permet d'optimiser le nombre d'entrées de chacune des portes « OU exclusif » de sortie. En fait, le corps de Galois est obtenu à partir d'un polynôme irréductible et primitif choisi parmi 16 polynômes primitifs possibles donnés dans la table de PETERSON décrite dans l'ouvrage « Error Correcting Code » MIP-Press-1972 ; il permet d'obtenir un polynôme G(x) générateur de code cyclique à deux coefficients A et B, symétrique. Si le symbole ⊕ désigne une opération de type « OU exclusif », pour la matrice A, les équations logiques des signaux fournis par les portes $A_0$ ... $A_7$ sont les suivantes :

$A_0 = D_7$, $A_1 = D_2 \oplus D_3$, $A_2 = D_2 + D_4 + D_7$, $A_3 = D_0 \oplus D_2 \oplus D_3 \oplus D_5 \oplus D_7$, $A_4 = D_1 \oplus D_3 \oplus D_4 \oplus D_6$, $A_5 = D_4 \oplus D_5$, $A_6 = D_0 \oplus D_5 \oplus D_6$, $A_7 = D_1 \oplus D_6 \oplus D_7$.

Pour la matrice B, les équations logiques des signaux fournis par les portes $B_0$ ... $B_7$ sont les suivantes :

$B_0 = D_6$, $B_1 = D_7$, $B_2 = D_0 + D_6$, $B_3 = D_1 \oplus D_6 \oplus D_7$, $B_4 = D_2 \oplus D_7$, $B_5 = D_3 + D_6$, $B_6 = D_4 \oplus D_7$, $B_7 = D_5$.

En fait, pour la matrice A, la donnée $D_0$ est transmise directement à une entrée des additionneurs $C_2$ et $C_5$ par liaison directe, sans qu'il soit nécessaire d'utiliser une porte $A_0$.

Pour la matrice B, on n'utilise pas de portes $B_0$, $B_1$ et $B_7$; les données $D_6$, $D_7$ et $D_5$ étant transmises directement par liaison directe aux entrées des additionneurs $C_3$ et $C_4$.

On n'a pas représenté en détails, la matrice E utilisée dans le deuxième mode de réalisation du système ; les mêmes considérations que celles qui ont abouti à l'obtention des matrices A et B, permettraient d'aboutir à la matrice E.

Les explications qui suivent vont permettre de mieux comprendre le fonctionnement du système de l'invention. Les divers modes de fonctionnement sont donnés dans le tableau ci-dessous ; dans ce tableau, on a indiqué par OUI ou par NON l'intervention ou la non-intervention des signaux de validation VIN, VCOEFF, VOUT, VREB, appliqués respectivement sur les portes $P_1$, $P_2$, $P_3$, $P_5$.

Tableau

| Mode de fonctionnement du système | Signal de validation VIN (portes $P_1$) | Signal de validation VCOEFF (portes $P_2$) | Signal de validation VOUT (portes $P_5$) | Signal de validation VREB portes $P_3$) |
|---|---|---|---|---|
| CALCUL (syndrome ou clé) | OUI | OUI | NON | OUI |
| VIDAGE CLE ET REMISE A ZERO DES REGISTRES | NON | OUI OU NON | OUI | NON |
| DECODAGE (syndrome) | NON | OUI | NON | OUI |
| CHARGEMENT (des registres) | OUI | NON | NON | OUI OU NON |
| VIDAGE CLE AVEC RETOUR AU CONTENU DES REGISTRES | NON | OUI | OUI | OUI |

— en mode « Calcul » le système calcule la clé ou le syndrome d'erreurs.

Les données à écrire (dans le cas du calcul de la CLE) ou à lire sur un disque par exemple (dans le cas du calcul du syndrome) sont injectées dans les registres par les entrées DIN qui sont donc validées (signal VIN = OUI). Les rebouclages au travers des matrices de multiplications sont également validés (Signal VREB = OUI). Les coefficients sont également validés (signal VCOEFF = OUI) tandis que les sorties ne sont pas validées (signal VOUT = NON).

— en mode « vidage » avec remise à zéro des registres, le système permet la concaténation de la clé au bloc de données utiles, l'extraction d'une configuration d'erreurs ou d'un syndrome à des fins de traitement.

Les rebouclages intermédiaires sont supprimés de sorte que les 15 registres parallèles à huit e. b. constituent un registre série/parallèle unique à quinze étages (signal VREB = NON et signal VCOEFF = OUI OU NON).

Les entrées DIN sont invalidées (signal VIN = NON) et les sorties DOUT sont validées (signal VOUT = OUI). Ceci permet, en quinze impulsions d'horloge, de transférer le contenu des registres, soit sur un disque par exemple après un calcul de clé, soit dans un microprocesseur pour certains cas d'analyse du syndrome. Les registres sont remis à zéro par les signaux REP et MR.

— en mode « décodage » on cherche à trouver des configurations connues d'erreurs simples ou

doubles particulières et ceci pendant 765 décalages successifs (ce qui correspond à la période du code entrelacé par 3 choisi en exemple).

Les rebouclages sont maintenus (signal VREB = OUI et signal VCOEFF = OUI) dans la même configuration que pour le mode « calcul », mais les entrées DIN sont invalidées (signal VIN = NON) tandis que les sorties DOUT sont validées (signal VOUT = NON).

Le contenu des registres est non seulement décalé à chaque impulsion d'horloge, mais il est modifié par suite de l'action des rebouclages. Le principe général est qu'au bout d'un certain nombre d'impulsions d'horloge la configuration d'erreurs apparaît dans les registres. Cette dernière condition est détectée par les signaux ES et EM, comme on le verra plus loin en détail.

— en mode « chargement » ce mode est utilisé pour effectuer certaines opérations telles que le chargement dans les registres d'une certaine configuration aux fins de décodage.

Les rebouclages sont supprimés (signal VREB = OUI OU NON et signal VCOEFF = NON) et les registres fonctionnent en registres à décalage simples comme pour le mode « vidage ». Mais ici les entrées DIN sont validées (signal VIN = OUI) tandis que les sorties DOUT sont invalidées (signal VOUT = NON).

Ce mode est utilisé :

soit pour initialiser les registres à un contenu autre que « tout à zéro », réalisé normalement par la ligne MR,

soit pour introduire, à partir d'un microprocesseur, des configurations particulières résultant de calculs logiciels intermédiaires.

— en mode « vidage de la clé avec retour au contenu des registres », les rebouclages par les circuits $R_1$ et $R_2$ sont validés (signal VREB = OUI). Les entrées sont invalidées (signal VIN = NON). Les coefficients et les sorties sont validés (signal VCOEFF = OUI et signal VOUT = OUI).

Le calcul d'une clé à ajouter à un message s'effectue de la manière suivante : la clé (r octets) est calculée à partir du bloc de données utiles de k octets. Cette clé est concaténée au bloc utile pour former un mot de code de k + r = n octets.

L'opération se décompose comme suit :

a) On initialise le système par un signal $\overline{MR}$ appliqué sur des entrées CL de remise à zéro des registres des ensembles X, Y, Z, T, U.

b) On met le circuit en mode « Calcul clé ou syndrome » (validation par les signaux VIN et VCOEFF).

c) Dans le même temps où l'on écrit les k octets utiles sur un disque par exemple, on les injecte dans le système en utilisant k impulsions de la même horloge H que pour l'écriture.

d) Immédiatement après la $k^{ème}$ impulsion d'horloge, on passe en mode « Vidage » (signal de validation VOUT, suppression de VIN).

e) On envoie r impulsions d'horloge supplémentaires, et les octets apparaissant à la sortie du registre (X, Y, Z, T, U) sont écrits sur un disque par exemple au moyen de la même horloge H.

Dans le cas d'un entrelacement par 3, la valeur maximale de k est 750. Mais en tronquant le code, on peut la réduire, par exemple, à 512 octets. Pour le même entrelacement par 3, la longueur de la clé est r = 15 octets.

Comme l'initialisation (étape a) consiste à mettre à zéro l'ensemble des registres du système tout se passe comme si l'on avait injecté 238 octets nuls (les registres restent à zéro puisque la ligne de rebouclage est en permanence à zéro) suivis des 512 octets utiles. Ce raisonnement explique le mécanisme très simple de la troncature que l'on retrouvera dans la phase lecture. Ici, la seule condition impérative est que la longueur (données utiles + clé) du mot de code réel soit inférieure ou égale à la période du code.

Les k octets de données utiles et les r octets de clé vont former un mot de code qui, lors de la phase lecture, sera lu d'une seule traite, sans qu'il y ait rupture de la phase de l'horloge lorsque l'on franchira la frontière entre données utiles et clé.

La lecture d'un message et la détection d'erreurs dans celui-ci consistent à engendrer le syndrome d'erreurs, à partir des données lues sur un disque par exemple et à tester ce syndrome.

Si le syndrome d'erreurs est nul on peut présumer qu'il n'y a pas d'erreur, et valider les informations temporairement emmagasinées dans la mémoire tampon MT.

Si le syndrome d'erreurs n'est pas nul, il y a une situation d'erreurs que l'on va tenter de résoudre comme indiqué plus loin.

L'opération de lecture d'un message et de détection d'erreurs se déroule de la manière suivante :

a) On initialise le système par le signal de commande $\overline{MR}$.

b) On met le système en mode « calcul clé ou syndrome » (validation par VIN, puis VOUT).

c) On injecte le nombre exact d'octets composant la totalité du bloc (c'est-à-dire données utiles + clé pour l'ensemble des mots de code entrelacés).

d) On vient tester le signal ER, à la sortie des moyens d'indication I.

Ce signal peut présenter le niveau logique 0 ou le niveau logique 1.

0 = pas d'erreur,

1 = présence d'une ou plusieurs erreurs.

Pendant toute la phase d'injection des données dans le système, ces données sont également chargées dans la mémoire tampon MT.

En présence d'erreurs (ER = 1), on va alors effectuer les opérations suivantes :

— le décodage du syndrome, c'est-à-dire l'identification des éléments constitutifs d'une situation d'erreurs sous forme d'un ensemble d'octets d'erreurs, chacun étant caractérisé par son emplacement dans le bloc et par son contenu.

— la prise de décision de correction,

— la correction effective, c'est-à-dire l'application dans la mémoire tampon, du masque de correction.

L'opération de décodage du syndrome est linéaire et réversible ; elle consiste dans la limite de la puissance du code, à remplacer ce syndrome par des informations directement utilisables sur chacune des erreurs (emplacement et contenu des erreurs). Toute l'information existe en fait dans le syndrome mais elle est cryptée et n'est pas directement reconnaissable pour permettre d'effectuer la correction des erreurs, ni même pour décider si l'on est capable de la faire.

Ce que l'on nomme contenu d'une erreur E, est la diférence logique entre les données d'origine D (supposées sans erreur) et les données D' lues avec erreur. L'opérateur logique concerné est le OU exclusif (⊕) opérant e. b. par e. b. sur l'ensemble du message. Ceci conduit à la relation $E = D \oplus D'$ strictement équivalente à $D = E \oplus D'$.

On remarque enfin que l'opération OU exclusif peut être faite pour chaque erreur, prise individuellement, et seulement aux emplacements où il y a une erreur. Dans le cas du code Reed-Solomon organisé en octets, l'opération sera donc faite octet par octet, et seulement pour les octets erronés.

On convient d'appeler « Erreur simple » une erreur n'affectant qu'un octet, dans un mot de code ou bloc donné, et « Erreur multiple » une erreur affectant plusieurs octets appartenant au même bloc ou mot de code, sans préciser la position relative de ces octets dans le mot de code. Enfin, on appelle « Erreur multiple groupée » une erreur telle que les octets qui la composent peuvent être cadrés dans une zone de longueur inférieure ou égale à celle de la clé.

Le décodage du syndrome est, dans les systèmes connus et dans le cas des erreurs multiples quelconques, une opération complexe faisant appel à des algorithmes mathématiques difficiles à exposer dans le présent document. En outre, le temps d'exécution de ces algorithmes peut devenir très grand pour des erreurs de multiplicité élevée.

Le système de l'invention permet un décodage élémentaire des erreurs simples et des erreurs multiples groupées au moyen d'un balayage, en un passage de la période du code. Ce procédé conduit à envoyer au système, sous le contrôle d'un compteur, le nombre voulu d'impulsions d'horloge et à venir tester, à chaque pas, le signal ES pour les erreurs simples et le signal EM pour les erreurs multiples groupées, sur les sorties des moyens d'indication I.

Une des propriétés remarquables de cette méthode est de pouvoir être appliquée à un code entrelacé, sans que l'on ait à s'occuper effectivement de la règle d'entrelacement. Pour cette raison, et pour rendre les explications plus évidentes, nous commencerons par en exposer le principe pour un code supposé non entrelacé.

Les figures 4a et 4b montrent ce qui se passe dans le cas d'une erreur simple. On a représenté le processus de balayage séquentiel du contenu des registres X, Y, Z, T lorsqu'un syndrome d'erreurs a été obtenu sous la forme d'une table à 5 colonnes et 256 lignes. Chaque colonne correspond dans l'ordre, à chacun des 5 ensembles X, Y, Z, T ou U du registre à décalage (X, Y, Z, T, U). Les lignes correspondent, dans l'ordre, aux états successifs du registre après chaque pas provoqué par l'envoi d'une impulsion d'horloge H. Chaque case représente le contenu d'un ensemble à un instant donné, c'est-à-dire qu'il figure un octet.

Pour la compréhension du mécanisme de décodage, il suffit de considérer les deux cas suivants sur ces figures :

— octet Tout à zéro (cases blanches),

— octet non nul (cases hachurées).

La première ligne du tableau représente schématiquement le contenu du registre à décalage (X, Y, Z, T, U) immédiatement en fin de lecture et avant d'entamer le processus de décodage. C'est le syndrome d'erreurs.

A chaque impulsion d'horloge, le contenu du registre évolue par l'action simultanée d'un décalage d'une position vers la droite, et des réinjections par les rebouclages intermédiaires. Ces derniers font que l'information est non seulement décalée, mais modifiée à chaque impulsion d'horloge. En règle générale, on aura 5 octets non nuls (on peut rencontrer un octet nul isolé de temps en temps), qui contiennent l'information sur les erreurs, mais toujours sous une forme cryptée.

Si l'on a une erreur simple, le processus va soudain placer quatre octets nuls dans les registres Y, Z, T et U. La valeur non nulle de X sera le contenu de l'erreur E cherchée.

Lors des quatre décalages suivants, et parce que la ligne de rebouclage alimentée par le dernier registre n de l'ensemble U est Tout à zéro, le contenu E va se déplacer de X en Y puis en Z, puis en T puis en U, les autres octets restant à zéro. Le dernier registre n est remis à zéro par un signal RAZn transmis par une porte $P_5$ de type ET qui reçoit le signal $\overline{MR}$ et un signal REP quand un syndrome d'erreurs est obtenu.

On dispose donc dans ce cas, et au choix, de cinq impulsions d'horloge pour piéger le contenu de l'erreur E, et l'extraire. Une simple fonction OU sur quatre des cinq variables x, y, z, t, u (variable = 0 si

octet nul ; variable = 1 si octet non nul) permet de détecter l'erreur simple signalée par le signal ES.

Après la 254$^{eme}$ impulsion d'horloge (255$^{ème}$ ligne), on aura parcouru une fois et une seule la période du code. Une 255$^{ème}$ impulsion d'horloge redonnera (en 256$^{eme}$ ligne), le contenu initial du registre, c'est-à-dire le syndrome.

On pourrait, pour le décodage des erreurs simples, s'en tenir là, c'est-à-dire :

— piéger l'erreur dans le registre n de l'ensemble U,

— extraire le contenu du registre n et le mettre dans la table mémoire d'erreurs TE,

— noter le comptage d'horloge du compteur c et le mettre en mémoire. (C'est l'emplacement de l'erreur dans le mot de code).

En fait, on va remettre à zéro le contenu du registre n de l'ensemble U une fois extrait, et avant l'impulsion d'horloge suivante. Il en résultera que le registre est maintenant entièrement vide et va le rester (figure 3b). La remise à zéro est effectuée grâce aux signaux $\overline{MR}$ et REP appliqués au circuit logique $P_6$ de remise à zéro.

En fait, c'est le dernier registre actif du dernier ensemble U qui sera remis à zéro. Dans le cas d'entrelacement par 3, les deux registres inactifs dans chaque ensemble, sont à zéro. La commande de remise à zéro du dernier registre actif du dernier ensemble U dépend des valeurs binaires des signaux $S_0$ et $S_1$ qui définissent la profondeur d'entrelacement.

L'intérêt de cette méthode apparaîtra plus loin.

Il se pourrait que le signal ES ne monte jamais. Cela veut simplement dire que l'on n'avait pas une erreur simple.

On va maintenant expliquer, à l'aide des figures 5a et 5b ce qui se passe dans le cas d'une erreur double groupée. Imaginons par exemple, que les deux octets erronés sont séparés par un octet valide.

Le processus séquentiel opère au début comme décrit ci-dessus. C'est-à-dire qu'une information cryptée évolue dans le registre. Soudain, apparaissent trois octets nuls parmi les quatre ensembles Y, Z, T, et U. Dans l'exemple, les octets nuls seront Y, T et U. L'octet non nul contenu dans X est le contenu $E_1$ de la première erreur, et l'octet non nul contenu dans Z est le contenu $E_2$ de la deuxième erreur.

Deux impulsions d'horloge supplémentaires vont amener $E_2$ en U et $E_1$ en Z. On dispose dans ce cas de trois impulsions d'horloge successives pour piéger globalement les erreurs $E_1$ et $E_2$ (et non pas 5 comme dans le cas d'une erreur simple). Si l'on s'abstient, il sera trop tard car le contenu du registre sera à nouveau crypté à l'impulsion d'horloge suivante.

L'erreur double peut être indiquée par le signal EM obtenu par la fonction majoritaire (2 parmi 5) sur les variables x, y, z, t et u ou mieux, par la fonction majoritaire composée :

$$u \cdot ET \cdot ([x, y, z, t] = 1)$$

(u, x, y, z, t étant les contenus des premiers registres des ensembles U, X, Y, Z, T).

On convient de piéger les erreurs $E_2$, en position U. On peut extraire $E_1$ et $E_2$ en passant en mode « vidage » en utilisant la méthode suivante, dont l'intérêt apparaîtra plus loin. Ayant extrait $E_2$ du dernier registre de l'ensemble U (validation par le signal VOUT), ce dernier registre est remis à zéro par l'envoi de la commande REP. Cela ne modifie pas le contenu $E_1$ de l'étage Z (dans notre exemple). En revanche, les quatre étages X, Y, T et U sont maintenant nuls, et l'on se trouve dans la même situation que ce qui se passait après l'impulsion d'horloge de rang n-2 du processus de décodage d'une erreur simple. Il suffit alors de reprendre le cycle de progression et d'attendre que l'erreur $E_1$ soit piégée dans le registre n de l'ensemble U. On peut utiliser pour cela la fonction ES = NON (x. OU. y. OU. z. OU. t) ou mieux modifier le piège à erreur double pour créer la fonction majoritaire composée, produisant le signal :

$$EM = u \cdot ET \cdot ([x, y, z, t] \leqslant 1)$$

qui inclut la fonction ES. Le processus est décrit à la figure 4b. La table de vérité de ES et EM est la suivante :

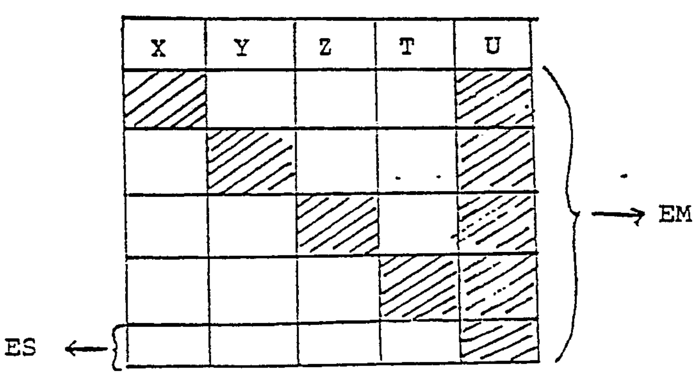

Les circuits logiques qui produisent ES, EM et ER dans les moyens d'indication I ne sont pas représentés en détail. Il est à la portée du technicien de concevoir ces circuits qui résolvent les équations logiques majoritaires indiquées ci-dessus.

On remarque que l'on n'aurait pas pu extraire simplement $E_1$ en espérant le voir atteindre la position U, si l'on n'avait pas fait la remise à zéro après l'extraction de $E_2$. En effet, $E_2$ réalimentant la ligne de rebouclage, $E_1$ aurait été perturbé à l'impulsion d'horloge suivante avant d'avoir pu atteindre la sortie du registre.

La méthode présente les avantages suivants :

— elle est applicable à des erreurs multiples groupées quelconques (dans les limites des possibilités du code choisi),

— elle est indépendante de l'entrelacement (que l'on n'a pas représenté sur les figures 4a, 4b et 5a, 5b),

— elle n'oblige pas à vider la totalité du registre, opération qui peut devenir lourde dans le cas d'un code entrelacé, à cause de la nécessité de trier les informations appartenant aux différents mots de code,

— elle permet enfin de venir tester le contenu du registre pour voir s'il est vide, n'importe quand, une fois que les erreurs ont été extraites.

En particulier, on pourra venir faire un test global du signal ER après le $254^{ème}$ coup d'horloge, qui indiquera si l'ensemble du registre (pour les différents mots de code) est vide, c'est-à-dire que l'on a pu décoder toutes les erreurs.

La définition donnée aux fonctions ES et EM permet à l'utilisateur de choisir entre deux options :

— une option erreurs doubles groupées (signal EM), capable de détecter les erreurs triples et de signaler l'existence éventuelle d'une erreur double quelconque,

— une option erreurs simples (signal ES) moins puissante, mais offrant une protection accrue contre le risque de fausse correction. (Dans cette option le système est cependant capable de signaler l'existence d'une éventuelle erreur double).

La numérotation des octets, dans le cas d'un entrelacement par 3, est représentée sur la figure 6.

— les 238 octets numérotés 764 à 527 correspondront aux zéros fictifs dus à la troncature du code. Le dispositif de décodage ne doit normalement jamais agir dans cette zone. Si cela se produit, c'est la preuve irréfutable que l'on s'apprête à faire une fausse correction,

— les 512 octets numérotés de 526 à 15 sont les octets utiles. En ôtant 15, on obtient donc une numérotation naturelle inverse des octets, ce qui est un avantage pour l'adressage dans la mémoire tampon,

— les 15 octets constituant la clé sont numérotés de 14 à 0 (le premier octet de la clé, repéré 14 correspondra à la sortie U du registre dans le syndrome, la longueur du registre étant égale à la longueur de la clé).

A la suite des opérations qui viennent d'être décrites, on va maintenant indiquer comment s'effectue la correction de multiplets erronés.

A l'issue de la phase de décodage, on dispose en mémoire d'une table TE des erreurs supposées avoir affecté le bloc de données.

Il s'agit maintenant de prendre une décision quant à la correction effective du bloc.

Comme il pourra s'agir d'erreurs multiples, et bien que la distance logique du code procure déjà une protection naturelle contre les risques de fausse correction, il y a lieu de prendre certaines précautions.

Le processus décrit jusqu'à présent est linéaire et réversible. C'est-à-dire qu'il est toujours possible de reconstituer le syndrome initial à partir des informations contenues dans la table.

En revanche, une fois la correction appliquée en mémoire tampon MT et dès que l'on aura dû effacer le contenu du registre et de la table d'erreur TE pour traiter les informations d'un nouveau bloc, il sera trop tard pour faire revenir en arrière dans le cas où une fausse correction aurait pollué le bloc que l'on vient de traiter.

Tout doit donc être mis en œuvre, au niveau de la présente phase, pour se prémunir contre les fausses corrections. En outre, on aura à faire un premier tri dans les adresses des erreurs décodées.

— Si l'adresse se situe à l'intérieur de la clé, on n'en tiendra généralement pas compte.

— Si l'adresse se situe dans la zone des zéros fictifs, on sera sûr de se trouver dans un cas de fausse correction. Mais on pourra l'éviter in extremis.

Le système étant correcteur d'erreurs multiples, on doit également s'intéresser à leur nombre. Compte tenu de l'entrelacement par 3, la table d'erreurs peut contenir entre 1 et 6 erreurs décodées, selon le tableau de la figure 7. L'examen des congruences modulo 3 entre les adresses des différentes erreurs permettra de connaître exactement le cas de figure dans lequel on se trouve et si ce cas est valide.

Après la décodification des erreurs et la décision de correction, on dispose en mémoire d'une table des erreurs (TE) que l'on désire effectivement corriger, sous la forme d'un certain nombre d'octets de correction et de leurs emplacements respectifs dans le bloc.

On dispose par ailleurs des données brutes dans la mémoire tampon MT.

La correction va consister à appliquer un masque de correction qui, pour le code Reed-Solomon choisi, va consister à effectuer l'opération : $D = D' + E$ pour chaque octet en erreur.

Cette opération peut être effectuée par un microprocesseur. Le fait de disposer, dans la table d'erreurs, de l'adresse naturelle des octets dans le bloc facilite l'opération de correction.

## Revendications

1. Système de détection et de correction d'erreurs de transmission dans un message traité selon un code cyclique de type REED-SOLOMON entrelacé, et constitué par au moins un sous-bloc utile de multiplets dont le nombre définit la profondeur d'entrelacement du code, comprenant :

— des ensembles successifs (X, Y, Z, T, U) de registres à décalages reliés en série, ayant chacun un nombre de registres à décalage égal à la profondeur d'entrelacement du code, le nombre des ensembles dépendant du degré du polynôme générateur du code cyclique choisi,

— des circuits de rebouclage entre les sorties et les entrées des différents registres, pour multiplier le message par les coefficients du polynôme générateur du code cyclique, obtenus à partir des éléments primitifs d'un corps de Galois prédéterminé,

— des moyens de détection ($D_1$, $D_2$, $D_3$, $D_4$, $D_5$) dont des entrées sont respectivement reliées à des sorties de chaque premier registre de chaque ensemble, pour détecter la présence d'un syndrome d'erreurs éventuelles dans le message, ce syndrome étant composé de l'ensemble des syndromes de chacun des sous-blocs,

— des moyens (D) de décodage du syndrome d'erreurs éventuelles reliés aux moyens de détection de ce syndrome, le décodage du syndrome d'erreurs étant effectué sous-bloc par sous-bloc,

caractérisé en ce que les moyens (D) de décodage du syndrome d'erreurs comprennent une mémoire (EC) de configurations d'erreurs, reliée aux moyens de détection ($D_1$, $D_2$, $D_3$, $D_4$, $D_5$) de ce syndrome, et des moyens (I) reliés à des sorties de la mémoire (EC) pour indiquer la présence d'erreurs (ER) dans tout le bloc de données et, parmi ces erreurs, l'existence d'erreurs simples (ES) ou d'erreurs multiples (EM) dans chacun des sous-blocs.

2. Système selon la revendication 1, caractérisé en ce que les moyens d'indication sont reliés à un compteur (C) recevant les impulsions d'une horloge de commande de décalage des registres (H) de manière à repérer les positions de chaque multiplet qui, dans le message, est affecté d'erreurs, et de manière à extraire, grâce à un signal (REP) d'extraction et de remise à zéro, un à un, du dernier registre du dernier ensemble, des multiplets représentant respectivement les configurations des erreurs éventuelles dans les multiplets, les moyens d'indication (I) comportant une logique permettant de mémoriser les éventuelles erreurs simples ou doubles groupées dans chacun des sous-blocs.

3. Système selon l'une quelconque des revendications 1 et 2, caractérisé en ce qu'il comprend une autre mémoire (TE), reliée aux sorties du dernier registre du dernier ensemble, pour enregistrer les positions des multiplets affectés d'erreurs.

4. Système selon la revendication 3, caractérisé en ce qu'il comprend une mémoire tampon (MT) dans laquelle est enregistré chaque bloc de données d'un message à décoder, les multiplets utiles du message étant accompagnés de multiplets constituant une clé, de sorte que lorsqu'aucune erreur n'est détectée, les multiplets utiles (VT) sont transmis directement à un utilisateur, et de sorte qu'en présence d'erreurs détectées, le contenu de l'autre mémoire (TE) permette de corriger par masquage dans la mémoire tampon (MT) les multiplets qui présentent des erreurs, avant leur transmission à un utilisateur.

5. Système selon la revendication 4, caractérisé en ce que les moyens de détection ($D_1$, $D_2$, $D_3$, $D_4$, $D_5$) de syndrome d'erreurs comprennent, pour chaque premier registre de chaque ensemble une porte de type « OU » dont les entrées sont reliées aux sorties de ce registre et dont une sortie est reliée à une entrée de la mémoire (EC) d'enregistrement des configurations d'erreurs.

## Claims

1. System for the detection and correction of transmission errors in a message processed according to an interleaved cyclic code of the REED-SOLOMON type, and constituted by at least one useful sub-block of bytes of which the number defines the depth of interleaving of the code, comprising :

— successive assemblies (X, Y, Z, T, U) of shift registers connected in series, each having a number of shift registers equal to the interleaving depth of the code, the number of assemblies depending on the degree of the polynomial generator of the cyclic code chosen,

— looping circuits between the outputs and the inputs of the different registers, in order to multiply the message by the coefficients of the polynomial generator of the cyclic code, obtained from the original elements of a predetermined Galois body,

— detection means ($D_1$, $D_2$, $D_3$, $D_4$, $D_5$) of which the inputs are respectively connected to the outputs of each first register of each assembly, in order to detect the presence of a syndrome of possible errors in the message, this syndrome being composed of the whole of the syndromes of each of the sub-blocks,

— means (D) for decoding the syndrome of possible errors connected to the detection means for this syndrome, the decoding of the syndrome of errors being effected sub-block by sub-block,

characterised in that the means (D) for decoding of the error syndrome comprises a memory (EC) of the configuration of errors, connected to the detection means ($D_1$, $D_2$, $D_3$, $D_4$, $D_5$) of this syndrome, and means (I) connected to the outputs of the memory (EC) for indicating the presence of errors (ER) in all the block of data, and amongst these errors, the existence of simple errors (ES) or multiple errors (EM) in each of the sub-blocks.

2. A system according to claim 1 characterised in that the indication means are connected to a counter (C) receiving pulses from a clock (H) for controlling the shift registers in a manner to reference the positions of each byte which, in the message, is affected by errors, and in a manner to extract, due to a signal (REP) for extraction and return to zero, one to one of the last register of the last assembly, of bytes representing respectively the configurations of the possible errors in the bytes, the indication means (I) comprising a logic means permitting to memorise the possible simple errors or double group errors in each of the sub groups.

3. A system according to either of claims 1 and 2, characterised in that it comprises another memory (TE), connected to the outputs of the last register of the last assembly, in order to store the positions of the bytes affected by errors.

4. A system according to claim 3, characterised in that it comprises a buffer memory (MT) in which are stored each block of data of a message to be decoded, the useful bytes of the message being accompanied by bytes constituting a key, so that when no error is detected, the useful bytes (VT) are transmitted directly to a utilisation means, and so that in the presence of detected errors, the contents of the other memory (TE) permits correction by masking in the buffer memory (MT) the bytes which present the errors, before their transmission to a utilisation means.

5. A system according to claim 4, characterised in that the detection means ($D_1$, $D_2$, $D_3$, $D_4$, $D_5$) of the error syndrome comprise, for each first register of each assembly an « OR » gate of which the inputs are connected to the outputs of this register and of which one output is connected to one input of the memory (EC) storing the configuration of errors.

**Patentansprüche**

1. System zur Erfassung und Korrektur von Übertragungsfehlern in einer Nachricht, die nach einem zyklischen verschachtelten Code vom Typ REED-SOLOMON bearbeitet wurde und gebildet ist aus wenigstens einem nutzbaren Unterblock von Multiplets, deren Anzahl die Verschachtelungstiefe des Codes angibt, enthaltend :

— aufeinanderfolgende Gruppen (X, Y, Z, T, U) von in Reihe geschalteten Schieberegistern, die jeweils eine Anzahl von Schieberegistern aufweisen, die gleich der Verschachtelungstiefe des Codes ist, wobei die Anzahl von Gruppen vom Grad des Polymers abhängt, durch welches der gewählte zyklische Code erzeugt wird,

— Rückschleifschaltungen zwischen den Ausgängen und den Eingängen der verschiedenen Register, um die Nachricht mit dem Koeffizienten des Generatorpolynoms für den zyklischen Code zu multiplizieren, welche aus den primitiven Elementen eines vorgegebenen Galois'schen Körpers erhalten werden,

— Detektionsmittel ($D_1$, $D_2$, $D_3$, $D_4$, $D_5$), deren Eingänge jeweils mit den Ausgängen jedes ersten Registers jeder Gruppe verbunden sind, um das Vorhandensein eines Syndroms von eventuellen Fehlern in der Nachricht festzustellen, wobei dieses Syndrom zusammengesetzt ist aus der Gesamtheit von Syndromen jedes der Unterblöcke,

— Mittel (D) zum Decodieren des Syndroms eventueller Fehler, angeschlossen an die Mittel zur Erfassung dieses Syndroms, wobei die Decodierung des Fehlersyndroms Unterblock für Unterblock geschieht,

dadurch gekennzeichnet, daß die Mittel (D) zum Decodieren des Fehlersyndroms einen Fehlerkonfiguration-Speicher (EC) umfassen, welcher an die Mittel ($D_1$, $D_2$, $D_3$, $D_4$, $D_5$) zur Erfassung dieses Syndroms angeschlossen ist, und Mittel (I) umfassen, welche an Ausgänge des Speichers (EC) angeschlossen sind, um die Anwesenheit von Fehlern (ER) in dem gesamten Datenblock und unter diesen Fehlern das Auftreten von einfachen Fehlern (ES) oder von Mehrfachfehlern (EM) in jedem der Unterblöcke anzuzeigen.

2. System nach Anspruch 1, dadurch gekennzeichnet, daß die Anzeigemittel an einen Zähler (C) angeschlossen sind, welcher die Impulse einer Zeitbasis zur Steuerung der Verschiebung der Register (H) empfängt, so daß die Stellungen jedes Multiplets erkannt werden können, das in der Nachricht fehlerbehaftet ist, und so daß durch Verwendung eines Extraktions- Und Nullrücksetzsignals (REP) aus dem letzten Register der letzten Gruppe jeweils einzeln Multiplets entnommen werden, welche jeweils die Konfigurationen der eventuellen Fehler in den Multiplets darstellen, wobei die Anzeigemittel (I) eine Logik umfassen, die es gestattet, die eventuellen Einfachfehler oder Doppelfehler zu speichern, welche in jedem der Unterblöcke gruppiert sind.

3. System nach Anspruch 1 oder 2, dadurch gekennzeichnet, daß es einen weiteren Speicher (TE) umfäßt, der an die Ausgänge des letzten Registers der letzten Gruppe angeschlossen ist, um die Positionen der mit Fehlern behafteten Multiplets aufzuzeichnen.

4. System nach Anspruch 3, dadurch gekennzeichnet, daß es einen Pufferspeicher (MT) umfaßt, worin jeder Datenblock einer zu decodierenden Nachricht gespeichert wird, wobei die nutzbaren Multiplets der Nachricht von Multiplets begleitet werden, welche einen Schlüssel bilden, so daß, wenn keinerlei Fehler erfaßt wird, die nutzbaren Multiplets (VT) direkt einem Anwender zugeführt werden, und daß bei Anwesenheit von erfaßten Fehlern der Inhalt des weiteren Speichers (TE) die durch Maskierung in

dem Pufferspeicher (MT) erfolgende Korrektur der fehlerbehafteten Multiplets vor ihrer Übertragung zu einem Anwender gestattet.

5. System nach Anspruch 4, dadurch gekennzeichnet, daß die Mittel ($D_1$, $D_2$, $D_3$, $D_4$, $D_5$) zur Erfassung von Fehlersyndromen für jedes erste Register jeder Gruppe eine OR-Torschaltung umfassen, deren Eingänge mit den Ausgängen dieses Registers verbunden sind und wovon ein Ausgang mit einem Eingang des Speichers (EC) zur Aufzeichnung von Fehlerkonfigurationen verbunden ist.

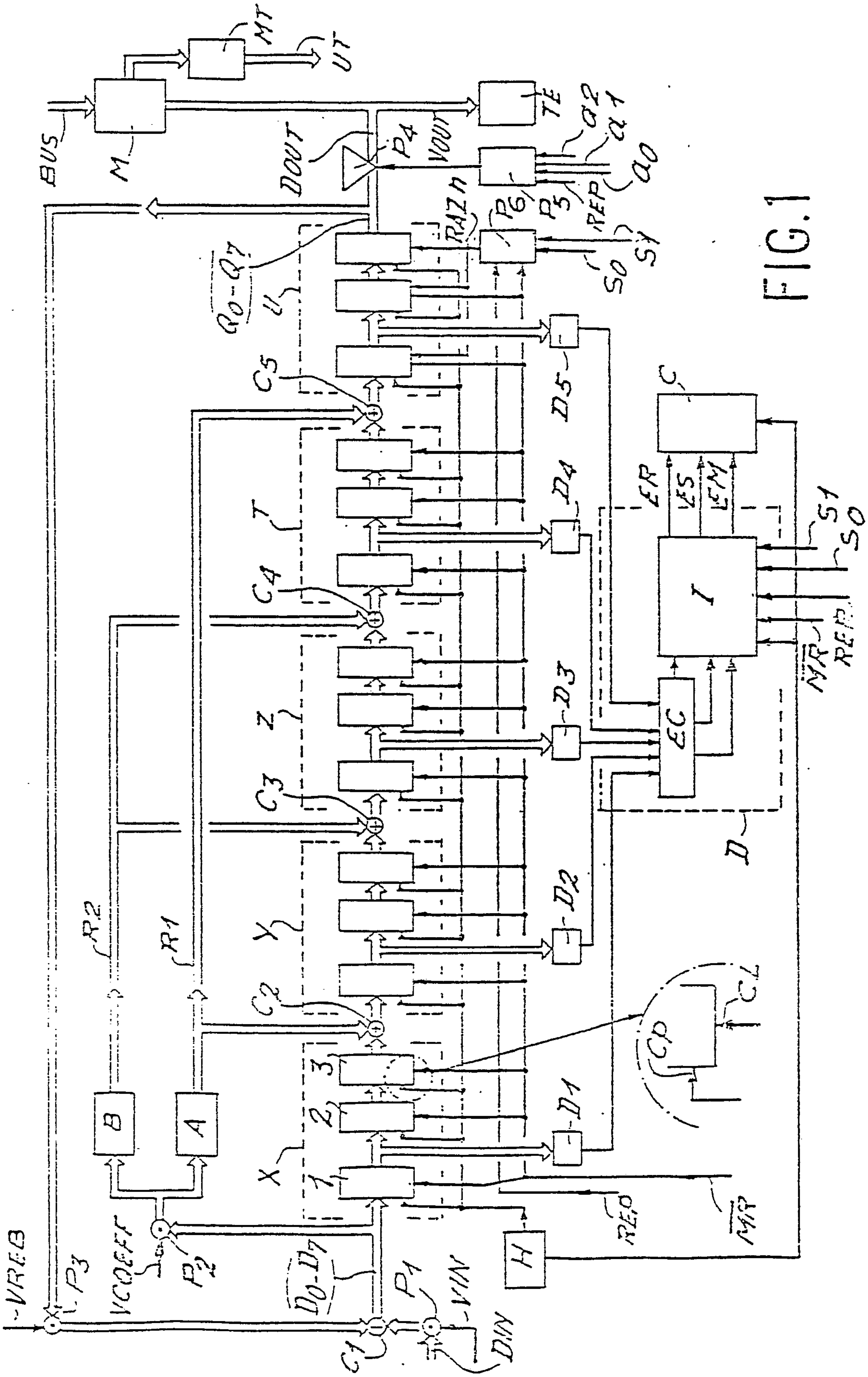
BUS
M
MT
UT
TE
DOUT
VOUT
P4
Q0-Q7
RAZ n
P6
P5
a2
a1
a0
REP
S0
S1
U
T
Z
Y
X
C5
C4
C3
C2
D1
D2
D3
D4
D5
C
ER
ES
EM
I
EC
D
NR
R2
R1
B
A
1
2
3
VREB
P3
VCOEFF
P2
D0-D7
P1
VIN
DIN
C1
H
REO
MP
CP
CL

FIG.1

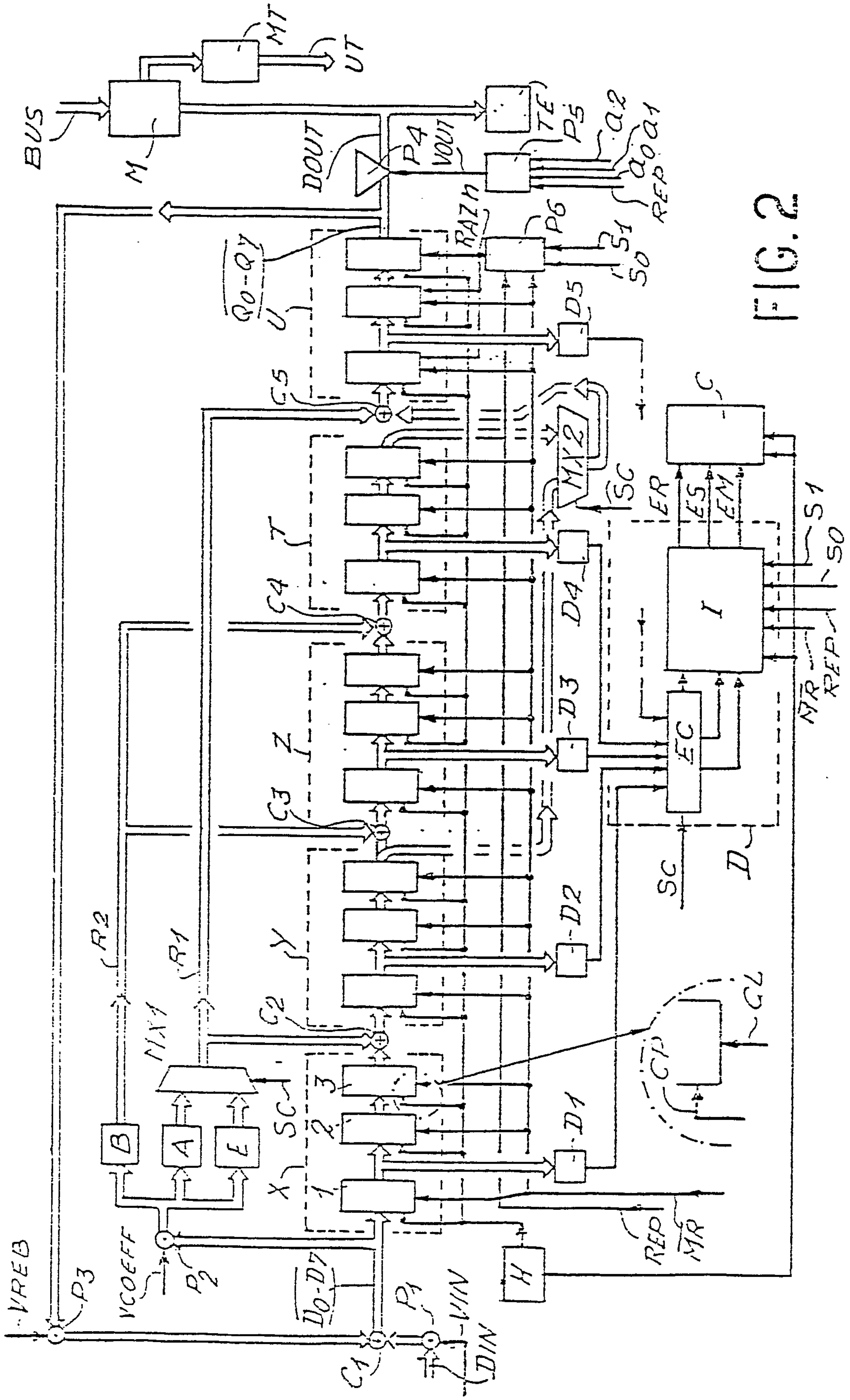
BUS
M
MT
UT
TE
DOUT
VOUT
P4
P5
P6
RAZh
a2
a1
a0
REP
S1
S0
Q0-QY
U
T
Z
Y
X
C1
C2
C3
C4
C5
D1
D2
D3
D4
D5
MX1
MX2
R1
R2
A
B
E
SC
EC
I
C
ER
ES
EM
D
MR
H
CL
CP
VREB
VCOEFF
P1
P2
P3
D0-D7
VIN
DIN
1
2
3

FIG. 2

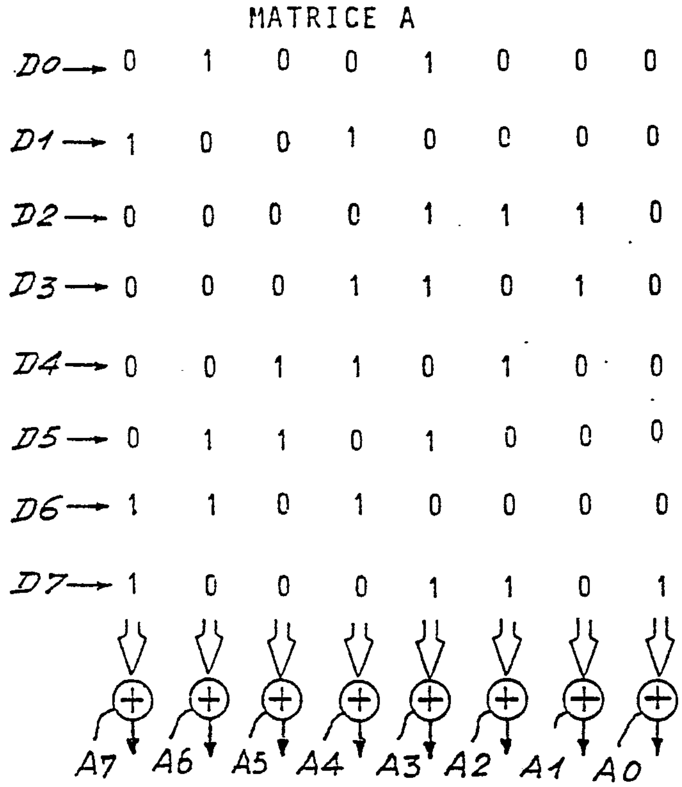


FIG.3a

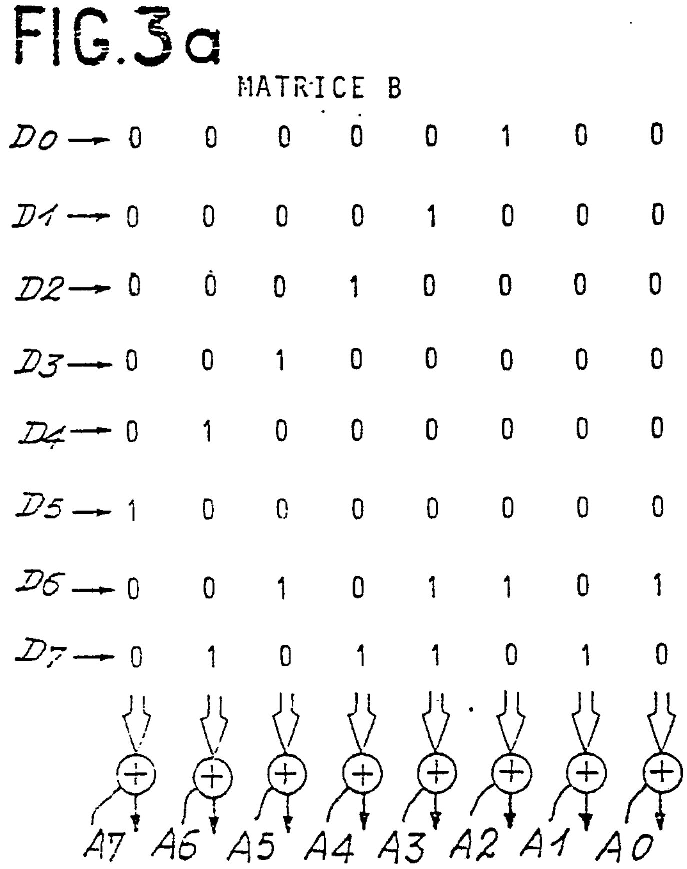


FIG.3b

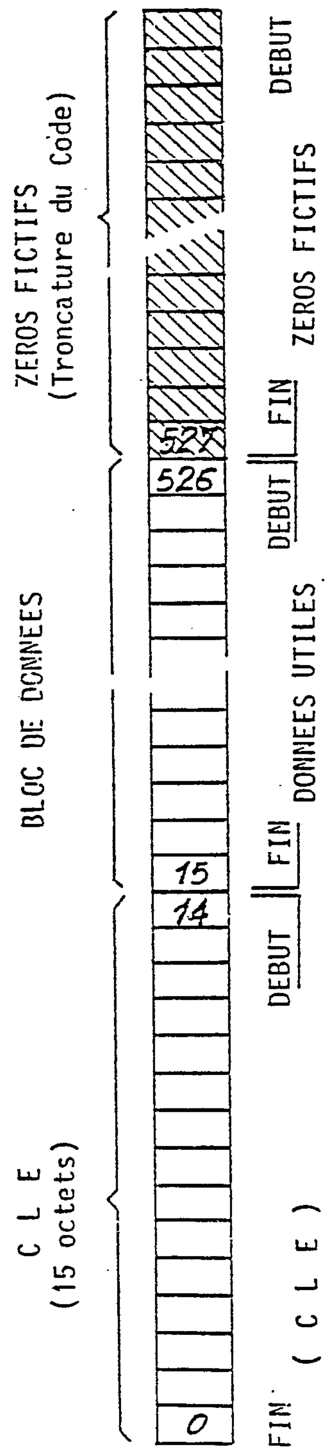


FIG.6

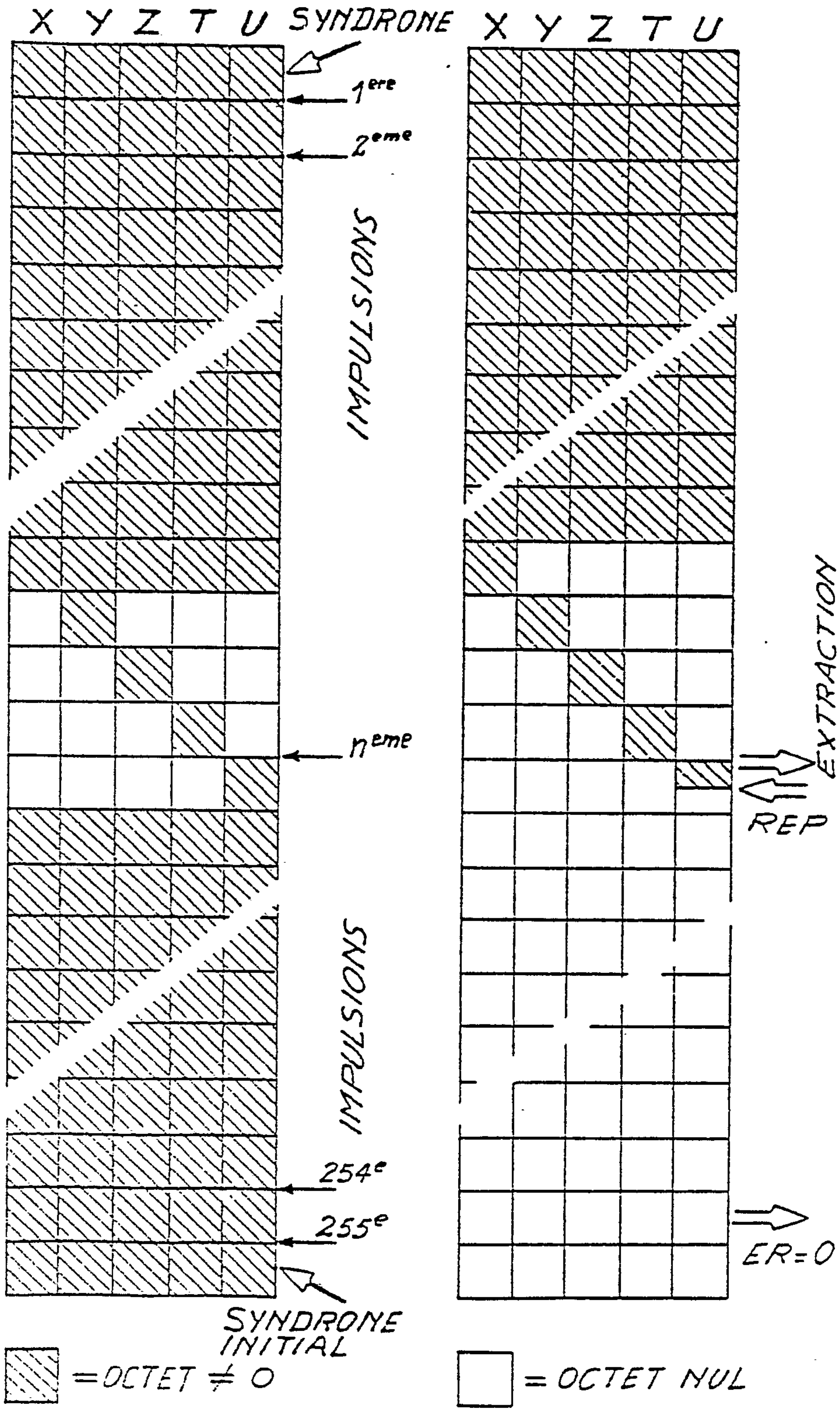
X Y Z T U
SYNDRONE
1ere
2eme
IMPULSIONS
neme
IMPULSIONS
254e
255e
SYNDRONE INITIAL
=OCTET ≠ O
X Y Z T U
EXTRACTION
REP
ER=O
=OCTET NUL

FIG.4a FIG.4b

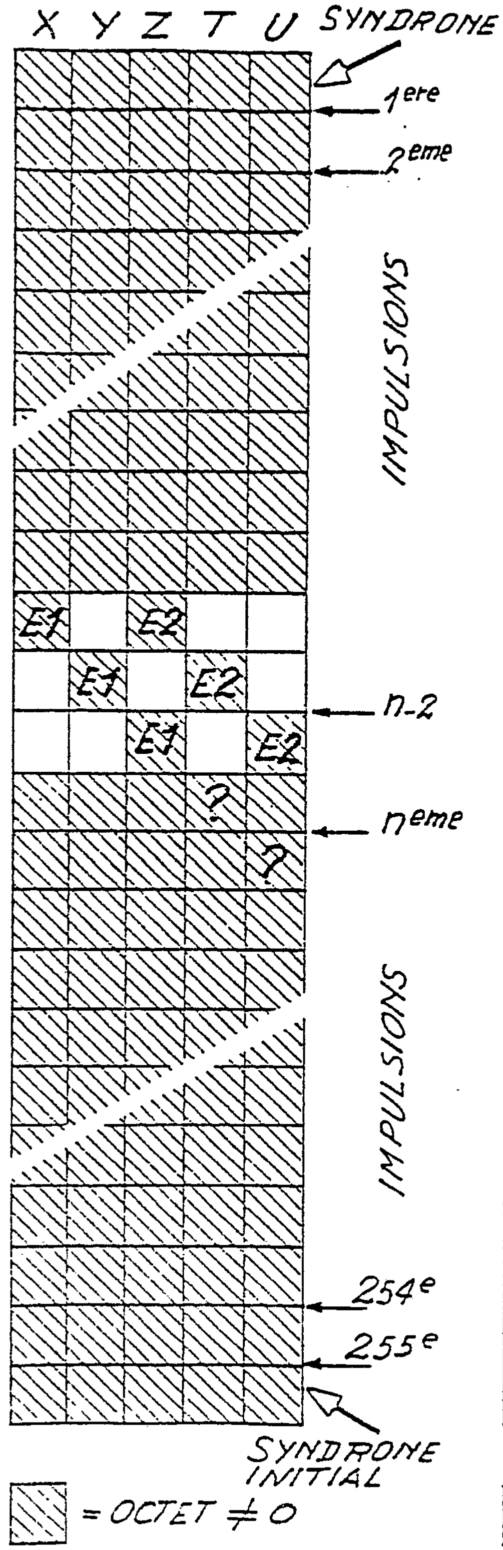
X Y Z T U
SYNDRONE
1ere
2eme
IMPULSIONS
E1
E2
n-2
neme
?
IMPULSIONS
254e
255e
SYNDRONE INITIAL
= OCTET ≠ 0

FIG.5a

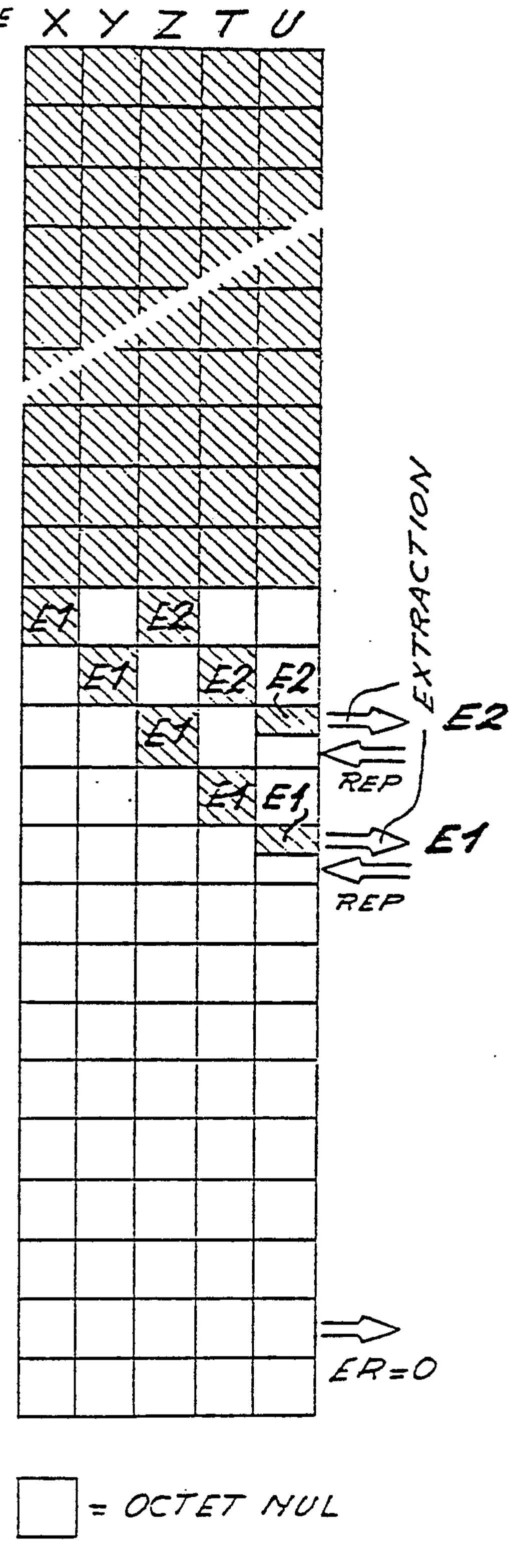
X Y Z T U
E1
E2
EXTRACTION
REP
ER=0
= OCTET NUL

FIG.5b

FIG.7

TABLE D'ERREURS (Cas d'un entrelacement par 3)

| NOMBRE D'ERREURS DECODEES | INTERPRETATIONS POSSIBLES |
|---|---|
| 6 | 3 erreurs doubles groupées |
| 5 | 2 erreurs doubles groupées + 1 erreur simple |
| 4 | 2 erreurs doubles groupées<br>ou<br>1 erreur double groupée + 2 erreurs simples |
| 3 | 3 erreurs simples<br>ou<br>1 erreur double groupée + 1 erreur simple |
| 2 | 1 erreur double groupée<br>ou<br>2 erreurs simples |
| 1 | 1 erreur simple |